(19) **Europäisches Patentamt**
**European Patent Office**
**Office européen des brevets**

(11) **EP 3 119 005 A1**

(12) **EUROPEAN PATENT APPLICATION**
published in accordance with Art. 153(4) EPC

(43) Date of publication:
**18.01.2017 Bulletin 2017/03**

(51) Int Cl.:
*H03M 13/37* (2006.01)   *H04L 1/00* (2006.01)

(21) Application number: **14885575.2**

(86) International application number:
**PCT/JP2014/056253**

(22) Date of filing: **11.03.2014**

(87) International publication number:
**WO 2015/136611 (17.09.2015 Gazette 2015/37)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Fujitsu Limited**
**Kawasaki-shi, Kanagawa 211-8588 (JP)**

(72) Inventor: **TOMITA, Yoshinori**
**Kawasaki-shi**
**Kanagawa 211-8588 (JP)**

(74) Representative: **Ward, Gregory Peter**
**Haseltine Lake LLP**
**Lincoln House**
**300 High Holborn**
**London WC1V 7JH (GB)**

(54) **DESIGN SUPPORT METHOD, DESIGN SUPPORT PROGRAM, DESIGN SUPPORT DEVICE AND STORAGE MEDIUM**

(57)   A design support apparatus (100) acquires an encoding matrix (ma1) and information indicative of a start timing. For each timing after the start timing indicated by the acquired information, among the timings corresponding to column vectors of the encoding matrix, the design support apparatus (100) identifies among first partial data stored in BRAMs, a first partial data overwritten by a second partial data at the timing. For each of the timings after the start timing, the design support apparatus (100) identifies an XOR operation based on the identified first partial data among multiple XOR operations. For each of the timings after the start timing, the design support apparatus (100) identifies among timings before the start timing included in the timings, a timing having the same operation result of the identified XOR operation as the operation result of the identified XOR operation based on the vector corresponding to the timing.

FIG.1

EP 3 119 005 A1

**Description**

TECHNICAL FIELD

The present invention related to a design support method, a design support program, a design support apparatus, and recording medium.

BACKGROUND ART

Conventionally, on the Internet, packets may be lost due to overflow of a buffer memory of a router present on a communication route. For example, in a typical communication protocol, Transmission Control Protocol/Internet Protocol (TCP/IP), communication speed may abruptly drop due to packet loss. Therefore, communication speed may be slowed significantly in a communication environment in which packet loss occurs.

A random parity stream (RPS) encoding process is known as a technique of overcoming the drawback of TCP/IP (see, e.g., Nonpatent Literature 1 and Patent Document 1 below). In the RPS encoding process, the data transmission side transmits redundant data and when packet occurs, the reception side reproduces the lost packets by using the redundant data. The RPS encoding process is conventionally executed by software, for example.

In another known technique, packet errors in packet transmission are detected from a parity calculation (see, e.g., Patent Documents 2 and 3 below).

Patent Document 1: Japanese Laid-Open Patent Publication No. 2007-258796
Patent Document 2: Japanese Laid-Open Patent Publication No. H10-190481
Patent Document 3: Japanese Laid-Open Patent Publication No. 2005-102037
Nonpatent Literature 1: Kameyama, H., Sato, Y., "Construction of High-Speed ASP System for Engineering Application Handling Large-Scale Data," [online], Multimedia, Distributed, Corporative, and Mobile (DICOMO 2008) Symposium, [retrieved on December 6, 2013], Internet <http://www.dicomo.org/2008/program/3H_abst.html>

DISCLOSURE OF INVENTION

PROBLEM TO BE SOLVED BY THE INVENTION

However, conventionally, implementing an encoding process by software has a problem in that the encoding process takes time. On the other hand, hardware implementation of an encoding process may result in a waiting time required for data transfer for the encoding process due to a small memory although the speed of the encoding process can be increased. This leads to a problem that the encoding process cannot efficiently be executed.

According to one aspect, an object of the present invention is to provide a design support method, a design support program, a design support apparatus, and recording medium enabling an encoding process to be more efficient.

MEANS FOR SOLVING PROBLEM

According to one aspect of the present invention, a design support method, a design support program, a design support apparatus, and a recording medium are proposed that support design of an encoding circuit and obtain a second number of encoded data by performing an encoding process for vectors of an encoding matrix having the second number of the vectors each having a predetermined number (hereinafter, "first number") of components, the second number being larger than the first number, the encoding process including a plurality of logical operations based on a plurality of partial data and the components of the vector, the plurality of partial data being obtained by dividing object data to be encoded into the first number and stored in the first number of storage areas. The design support method, design support program, design support apparatus, and recording medium further acquire the encoding matrix; acquire information indicative of a start timing of starting storage of a plurality of second partial data into the storage areas among timings corresponding to the vectors in the encoding process based on a plurality of first partial data and the components of the vectors of the encoding matrix, the plurality of second partial data being obtained by dividing second object data to be encoded, the plurality of first partial data being obtained by dividing first object data to be encoded and being stored in the storage areas; identify for each of the timings after the start timing indicated by the acquired information among the timings, first partial data overwritten by the second partial data at the timing among the plurality of first partial data stored in the storage areas; identify for each of the timings after the start timing, a logical operation based on the identified first partial data among the plurality of logical operations when among the components of the vector corresponding to the timing, a component corresponding to the identified first partial data is a predetermined value; and identify for each of timings after the start timing, a timing among timings before the start timing included in the timings and having a same operation result of the identified logical operation as the operation result of the identified logical operation based on the vector corresponding to the timing.

EFFECT OF THE INVENTION

According to an aspect of the present invention, the encoding process can be made more efficient.

BRIEF DESCRIPTION OF DRAWINGS

FIG. 1 is an explanatory diagram of an example of operation of a design support apparatus according to the present invention;

FIG. 2 is an explanatory diagram of an example of an RPS encoding process at the time of data transmission;

FIG. 3 is an explanatory diagram of an example of an RPS decoding process at the time of data reception;

FIG. 4 is an explanatory diagram of an example of a system configuration for transmitting data;

FIG. 5 is an explanatory diagram of examples of blocks in a FPGA;

FIG. 6 is an explanatory diagram of an encoding circuit example;

FIG. 7 is an explanatory diagram of an example of a portion an encoding circuit;

FIG. 8 is an explanatory diagram of modification examples of partial circuits;

FIG. 9 is an explanatory diagram of an encoding circuit example 2;

FIG. 10 is a block diagram of an example of hardware configuration of the design support apparatus according to an embodiment;

FIG. 11 is a block diagram of an example of a functional configuration of the design support apparatus;

FIG. 12 is an explanatory diagram of an encoding matrix example;

FIG. 13 is an explanatory diagram (part 1) of an access timing example when an acceleration number is zero;

FIG. 14 is an explanatory diagram (part 2) of an access timing example when the acceleration number is zero;

FIG. 15 is an explanatory diagram of a BRAM distribution example in which data is overwritten when supply of input blocks is accelerated;

FIG. 16 is an explanatory diagram of an access timing example when the acceleration number is 1;

FIG. 17 is an explanatory diagram of an access timing example when the acceleration number is 2;

FIG. 18 is an explanatory diagram of an access timing example when the acceleration number is 3;

FIG. 19 is an explanatory diagram of an access timing example when the acceleration number is 4;

FIG. 20 is an explanatory diagram of an access timing example when the acceleration number is 5;

FIG. 21 is an explanatory diagram of an access timing example when the acceleration number is 6;

FIG. 22 is an explanatory diagram of an access timing example when the acceleration number is 7;

FIG. 23 is an explanatory diagram of an example of the encoding circuit 101 when the acceleration number is 2 or 3;

FIG. 24 is an explanatory diagram of an example of the encoding circuit 101 when the acceleration number is 4;

FIG. 25 is an explanatory diagram of a position example of the BRAMs;

FIG. 26 is an explanatory diagram of a template logical expression;

FIG. 27 is an explanatory diagram of a correspondence relation between variables and BRAM positions;

FIG. 28 is an explanatory diagram of an example of a program solving the BRAM assignment problem;

FIG. 29 is an explanatory diagram of an example of a circuit description to be generated;

FIG. 30 is an explanatory diagram of an encoding circuit 101 and a control circuit controlling the encoding circuit 101;

FIG. 31 is an explanatory diagram of an operation example of a circuit depicted in FIG. 30;

FIG. 32 is an explanatory diagram of an accelerated execution process example;

FIG. 33 is an explanatory diagram of an example of a circuit configuration for executing an accelerated execution process;

FIG. 34 is an explanatory diagram of an example of interchanging column vectors of an encoding matrix;

FIG. 35 is an explanatory diagram of an example of changing the number of BRAMs used according to interchanging of the column vectors; and

FIGs. 36 and 37 are flowcharts of an example of a support process procedure by the design support apparatus.

BEST MODE(S) FOR CARRYING OUT THE INVENTION

Embodiments of a design support method, a design support program, a design support apparatus, and a recording medium according to the present invention will be described in detail with reference to the accompanying drawings.

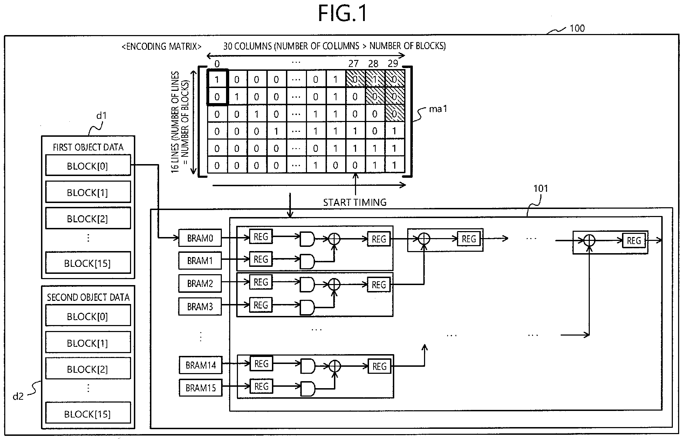

FIG. 1 is an explanatory diagram of an example of operation of a design support apparatus according to the present invention. A design support apparatus 100 is a computer configured to support the design of an encoding circuit 101. The encoding circuit 101 acquires encoded data by executing an encoding process with an encoding matrix ma1 and multiple partial data. The encoded data is herein referred to as an encoded block. The encoding matrix ma1 has a second number of vectors each having a predetermined number (hereinafter referred to as the "first number") of the multiple partial data obtained by dividing object data to be encoded, and the second number is larger than the first number. The encoding process in this case is an RPS encoding process, for example. The partial data are herein referred to as blocks. In the example of FIG. 1, the object data is divided into 16 blocks. The encoding matrix ma1 has 30 column vectors each having the first number of values, i.e., 16 values. The column vectors have components differing depending on the column vectors. In this embodiment, multiple blocks subjected to the encoding process by the encoding circuit 101 are respectively stored in multiple storage areas. The storage areas are herein referred to as block random access memories (BRAMs). The BRAMs are a type of RAM utilizable in a field programmable gate array (FPGA).

Conventionally, for example, if software executing the RPS encoding process outputs encoded data at 0.5 [Gbps], the encoded data is transmitted at 0.5 [Gbps] even in the communication bandwidth of 1 [Gbps]. Although the recent main stream communication bandwidth of international communication lines is about 100 [Mbps], if the communication bandwidth is increased to 10 [Gbps] in the future, the communication bandwidth cannot be utilized efficiently by a software process. With regard to situations in which RPS encoding and decoding processes are utilized, a network scale is assumed to spread to the extent of connecting across countries. Therefore, in this embodiment, the RPS encoding process is implemented by hardware to increase the speed of the encoding process. However, if the RPS encoding process is hardware-implemented by utilizing an FPGA, etc., the object data to be encoded must be stored in a BRAM etc., and a small capacity of the BRAM leads to a longer data transfer waiting time for storing the object data into the BRAM, etc. Therefore, the communication bandwidth cannot be utilized efficiently.

Thus, for each timing during accelerated execution, the design support apparatus 100 uses the encoding matrix ma1 to identify an operation based on data overwritten by the accelerated execution and another timing having the same result of the operation as the timing. This enables the design of the encoding circuit 101 capable of accelerated execution memory savings. Therefore, an encoding process can efficiently be executed. Efficiently executing an encoding process means that the process can be executed with high throughput even with memory savings.

When one encoded block is generated in the encoding circuit 101, one column vector is input to one of AND circuits included in the encoding circuit 101. As a result, it is determined which block is input to an XOR operation by an XOR circuit. In this embodiment, since the output data amount is increased by redundant data, "(data input rate)<(data output rate)" is satisfied as a precondition.

The design support apparatus 100 first acquires the encoding matrix ma1. Subsequently, out of multiple timings corresponding to column vectors included in the encoding matrix ma1 in an encoding process, the design support apparatus 100 acquires information indicative of a timing of starting storage of multiple second partial data acquired by dividing second object data d2 to be encoded into BRAMs. This encoding process is an encoding process based on multiple first partial data that are acquired by dividing first object data d1 to be encoded and that are stored in the BRAMs and the components of vectors of the encoding matrix ma1. The information indicative of the timing may be a number of the column vector corresponding to the timing or may be an acceleration number described later. For example, in the example of FIG. 1, the start timing is the timing corresponding to a column vector 27 among column vectors 0 to 29.

Subsequently, among the timings, for each timing after the start timing indicated by the acquired information, the design support apparatus 100 identifies among multiple first blocks stored in the BRAMs, the first partial data overwritten by a second block at the timing. In the example of FIG. 1, the first block stored in a BRAM 0 is overwritten with respect to the column vector 27. The first blocks stored in the BRAMs 0 and 1 are overwritten with respect to the column vector 28. The first blocks stored from the BRAMs 0 to 2 are overwritten with respect to the column vector 29.

Subsequently, for each of timings after the start timing, the design support apparatus 100 identifies a logical operation based on the identified first block if the components of the column vector corresponding to the timing include a component corresponding to the identified first block and having a predetermined value. In the example of FIG. 1, the predetermined value is one. This logical operation is an XOR operation. In the example of FIG. 1, among the components of the column vector 28, the component corresponding to the first block stored in the BRAM 0 is one. Among the components of the column vectors 27 and 29, the components corresponding to the identified first block are zero. In this case, for example, the design support apparatus 100 identifies the XOR operation of the XOR circuit through which the data of the BRAM 0 passes, among the XOR circuits of the encoding circuit 101.

Among the timings, for each of timings after the start timing, the design support apparatus 100 then identifies a timing having the same operation result as that of the identified XOR operation among timings before the start timing. The operation result of the identified XOR operation is an operation result based on the vector corresponding to the timing of the identified XOR operation. For example, since the operation result of the identified logical operation based on the column vector 0 and the operation result of the identified logical operation based on the column vector 28 are the same (in other words, both the column vector 0 and the column vector 28 have equal partial column vectors [1 0] composed of zeroth and first factors and therefor have the same XOR operation results), the design support apparatus 100 identifies the timing corresponding to the column vector 0.

Although not depicted in FIG. 1, the design support apparatus 100 determines whether two different timings of the timings after the start timing have the same identified logical operations and different operation results of the identified logical operations. If the two different timings have the same identified logical operations and different operation results of the identified logical operations, the design support apparatus 100 executes the process of identifying the logical operation and the process of identifying the timing such that the identified logical operations do not overlap between the two different timings.

This enables the design of the encoding circuit 101 capable of accelerated execution with memory savings. Therefore, the encoding process can be executed more efficiently.

Although not depicted in FIG. 1, the design support apparatus 100 generates circuit information representative of the encoding circuit 101 and a control circuit based on the identified logical operation and the identified timing. The generated encoding circuit 101 is a circuit that is the encoding circuit 101 provided with a BRAM storing a calculation result of a logical operation identified for each timing after the start timing. The control circuit is a circuit providing the control of storing into a BRAM, a calculation result of the identified logical operation at the timing identified for each of the timings after the start timing. As a result, since the circuit information representative of the encoding circuit 101 is automatically acquired, a designer's labor can be eliminated.

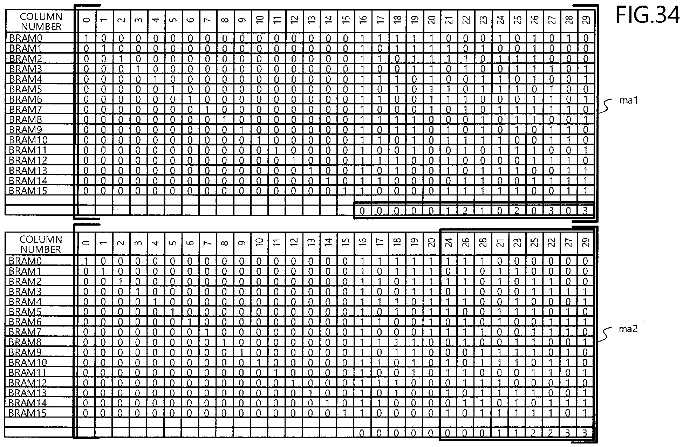

Although not depicted in FIG. 1, the design support apparatus 100 counts the number of consecutive times a value different from the predetermined value appears from a first line for each of vectors after the first number among the column vectors of the acquired encoding matrix ma1. As described above, the predetermined value is one, and the value different from the predetermined value is zero. Based on the encoding matrix ma1, the design support apparatus 100 generates an encoding matrix with the vectors after the first number sorted in ascending order of the counted number of the times that the value different from the predetermined value appears. An example of the sorted encoding matrix is depicted in FIG. 34 described later. The design support apparatus 100 uses the generated encoding matrix ma1 to execute the process of identifying the logical operation and the process of identifying the timing described above. As a result, more accelerated execution is enabled with a small memory capacity.

(RPS Encoding/Decoding)

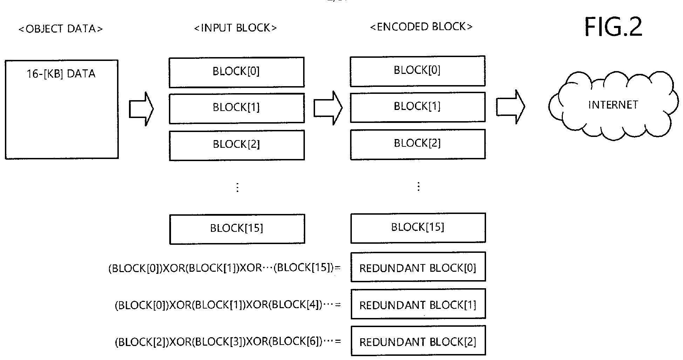

FIG. 2 is an explanatory diagram of an example of an RPS encoding process at the time of data transmission. An RPS encoding utilized in this embodiment will be described briefly. On the Internet, a packet may be lost due to an overflow of a buffer memory of a router present on a communication route. For example, in a typical communication protocol, TCP/IP, the a communication speed may drop abruptly due to packet loss. Therefore, the communication speed may be slowed significantly in a communication environment in which packet loss often occurs.

An RPS encoding process is known as a technique of overcoming the drawback of TCP/IP. The data transmission side of the RPS encoding process transmits redundant data and, if packet loss occurs, the reception side of the RPS encoding process reproduces the lost packets by using the redundant data. This leads to a reduction in the number of times that data is retransmitted in the case of packet loss.

As depicted in FIG. 2, in the RPS encoding process, for example, 16-[KB] data is cut into 1-[KB] blocks. In this example, the 16-[KB] data is cut into blocks [0] to [15]. Subsequently, in the RPS encoding process, the blocks [0] to [15] are directly transmitted. In the RPS encoding process, multiple redundant blocks are generated by executing an XOR operation for each available combination among the blocks [0] to [15] and are transmitted.

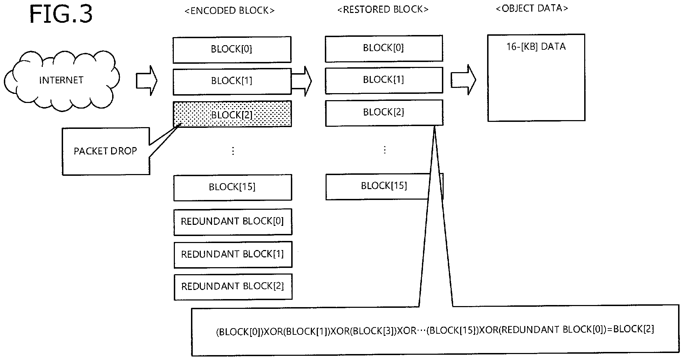

FIG. 3 is an explanatory diagram of an example of an RPS decoding process at the time of data reception. For data received through the Internet, the RPS decoding process includes a process checking whether the data is normal, a process of checking whether a lost packet exists, a process of removing a packet header to extract an RPS block. In the example of FIG. 3, it is assumed that the block [2] cannot be received due to packet loss. Therefore, in the RPS decoding process, the block [2] is reproduced by utilizing the blocks [0], [1], [3] to [15] and the redundant block [0]. In the RPS decoding process, the original 16-[KB] data is formed by utilizing the received 16 or more blocks (including the redundant blocks).

Although the 16-[KB] data is divided by 1 [KB] in the examples of FIGs. 2 and 3, a size of original data, a method of dividing data, and a method of calculating redundant blocks are not particularly limited.

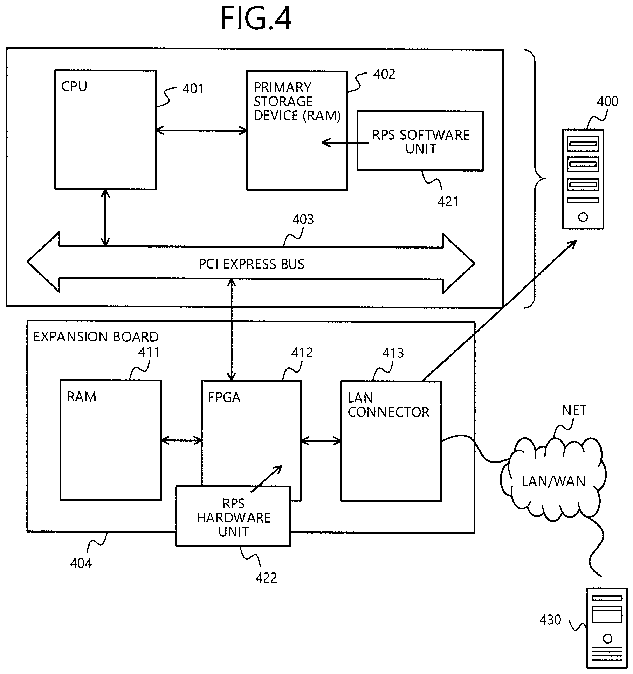

FIG. 4 is an explanatory diagram of an example of a system configuration for transmitting data. A system 400 has a CPU 401, a primary storage device 402, and an expansion board 404. The CPU 401 and the expansion board 404 are connected through a PCI EXPRESS bus 403. For example, the expansion board 404 is connected to an expansion slot disposed in a server that is the design support apparatus 100.

The expansion board 404 has a RAM 411, an FPGA 412, and a LAN connector 413. For the FPGA 412, the LAN connector is connected via a switch and a router through a network NET such as a LAN and a WAN to another server such as a data reception host 430.

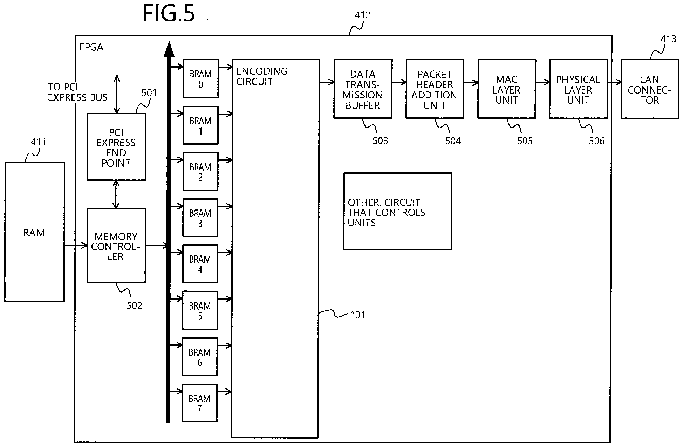

FIG. 5 is an explanatory diagram of examples of blocks in the FPGA. Blocks in the FPGA 412 depicted in FIG. 5 are examples of blocks representative of an internal configuration after the encoding circuit 101 is programmed. The FPGA 412 has a PCI EXPRESS end point 501, a memory controller 502, multiple BRAMs, the encoding circuit 101, a data transmission buffer 503, a packet header addition unit 504, a MAC layer unit 505, and a physical layer unit 506. The FPGA 412 additionally has a circuit controlling the units.

The memory controller 502 and the multiple BRAMs are connected through a bus. The memory controller 502 has the RAM 411 depicted in FIG. 4 and a function of controlling the multiple BRAMs and accepts an instruction from the CPU 401 depicted in FIG. 4 through the PCI EXPRESS end point 501. For example, the memory controller 502 stores data from the RAM 411 into the BRAMs. The PCI EXPRESS end point 501 is connected to the PCI EXPRESS bus 403 depicted in FIG. 4 and the memory controller 502.

The encoding circuit 101 performs the PRS encoding of the data from the BRAMs. The data transmission buffer 503 temporarily stores the encoded data from the encoding circuit 101. The packet header addition unit 504 adds a header of a packet based on, for example, User Datagram Protocol (UDP)/IP protocol, to the encoded data. The MAC layer unit 505 executes, for example, a process after the UDP/IP protocol, a process corresponding to a protocol of the MAC layer, etc. The physical layer unit 506 executes a process for sending a signal to an analogue signal medium using electricity, light, etc., for the digital data from the MAC layer unit 505, for example. The physical layer unit 506 is connected to the LAN connector 413.

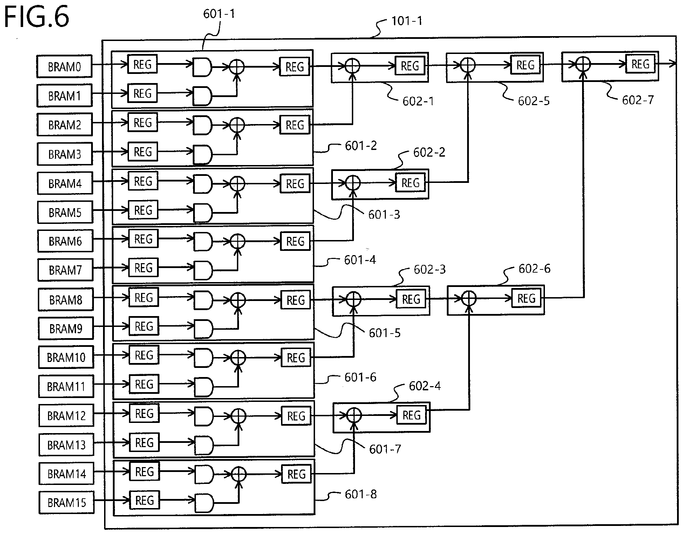

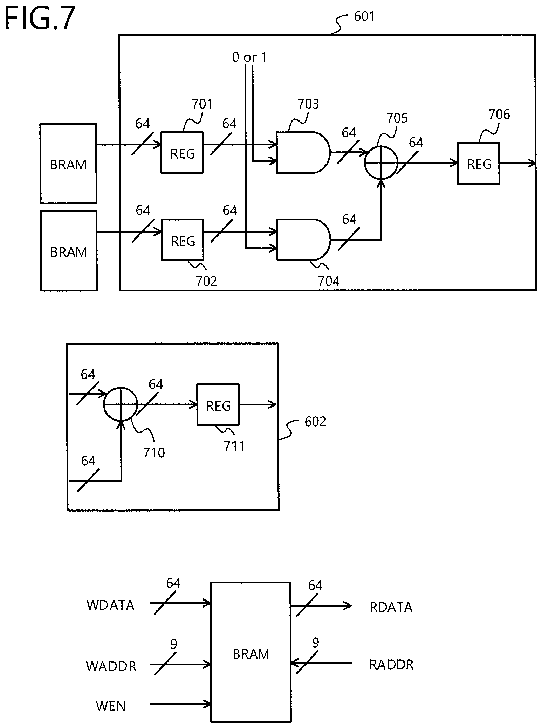

FIG. 6 is an explanatory diagram of an encoding circuit example. FIG. 7 is an explanatory diagram of an example of a portion the encoding circuit. In the example of FIG. 6, the number of the BRAMS storing data to be input to an encoding circuit 101-1 is 16. The encoding circuit 101-1 depicted in FIG. 6 is a circuit corresponding to the encoding process. The encoding circuit 101-1 has partial circuits 601-1 to 601-8 and partial circuits 602-1 to 602-8.

As depicted in FIG. 7, a partial circuit 601 has registers 701, 702, AND circuits 703, 704, an XOR circuit 705, and a register 706. The registers 701, 702 temporarily store data from the BRAMs. As depicted in FIG. 7, the BRAMs are 36-[Kbit] RAMs according to a certain configuration example and utilized with 72 bits per word and the word count of 512 and can retain four 1-[KB (Byte)] input blocks. The AND circuits 703, 704 each use a signal from the registers and a signal of zero or one as input to output a logical AND operation result to the XOR circuit. For the signal of zero or one, for example, a corresponding value in the encoding matrix is input. The XOR circuit 705 uses the output signals from the two AND circuits 703, 704 as input to output an operation result to the register 706.

As depicted in FIG. 7, a partial circuit 602 has an XOR circuit 710 and a register 711. The XOR circuit 710 uses output signals from the registers 706 as input to output an operation result of an XOR operation to the register 711. The register 711 temporarily stores the output signal of the XOR circuit. As depicted in FIG. 6, the encoding circuit 101 is provided with the partial circuits 602 as many as (the number of BRAMs)/2, and the partial circuits 602 are disposed as many as the number at which the output signals converge to one signal.

Respective processes of an RPS software unit 421 depicted in FIG. 4 and an RPS hardware unit 422 depicted in FIG. 4 will briefly be described. For example, the RPS software unit 421 executed by the CPU 401 stores object data desired to be transmitted into a transfer buffer area of the primary storage device 402. The RPS software unit 421 gives an instruction for execution to the RPS hardware unit 422. The RPS hardware unit 422 includes the encoding circuit 101 and a control circuit controlling the encoding circuit 101.

(1) With regard to the RPS hardware unit 422, a DMA circuit in the FPGA 412 transfers data in a transfer buffer to the RAM 411. (2) The RPS hardware unit 422 sequentially writes a total of 16-[KB] data, 1 [KB] at a time, from the RAM 411 into the BRAMs 0 to 15. (3) The RPS hardware unit 422 sets j=0. (4) The RPS hardware unit 422 inputs a value of a j-th column of an encoding matrix described later to the AND circuit of the encoding circuit 101. (5) The RPS hardware unit 422 reads addresses 0 to 1023 of the BRAMs 0 to 15 and passes 1-[KB] encoded data output after an XOR operation to subsequent processes of the data transmission buffer 503, the packet header addition unit 504, etc. (6) The RPS hardware unit 422 sets j=j+1, repeats (4) to (6) until j becomes larger than the number of columns of the encoding matrix, and returns to (2) when j becomes larger than the number of columns of the encoding matrix. If a data reception completion notification is received from the data reception host 430 before j reaches the number of columns of the encoding matrix, the RPS hardware unit 422 returns to (2) because it is no longer necessary to send a redundant block. Although not depicted in FIG. 4, a circuit for receiving the data reception completion notification is included in the RPS hardware unit 422. In this way, the hardware and the software can encode and transmit the object data in a coordinated manner.

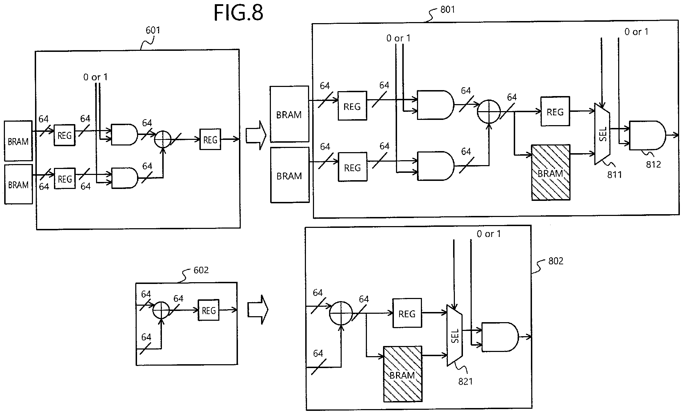

FIG. 8 is an explanatory diagram of modification examples of the partial circuits. A partial circuit 801 is an example of disposing a BRAM storing an operation result of the XOR operation by the XOR circuit included in the partial circuit 601. As compared to the partial circuit 601, the partial circuit 801 is provided with a BRAM storing an output signal from the XOR circuit and a selection circuit 811 selectively outputting an output signal from the register and an output signal from the BRAM. The partial circuit 801 is provided with an AND circuit 812 controlling whether a signal from the selection circuit 811 is output.

A partial circuit 802 is an example of disposing a BRAM storing an operation result of the XOR operation by the XOR circuit included in the partial circuit 602. As compared to the partial circuit 602, the partial circuit 802 is provided with a BRAM storing an output signal from the XOR circuit and a selection circuit 821 selectively outputting an output signal from the register and an output signal from the BRAM.

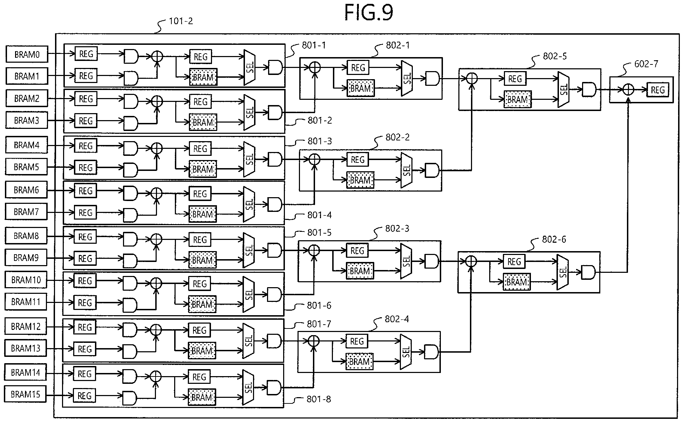

FIG. 9 is an explanatory diagram of an encoding circuit example 2. An encoding circuit 101-2 is a circuit in which the partial circuits 601 included in the encoding circuit 101-1 are replaced with the partial circuits 801. The encoding circuit 101-2 is a circuit in which the partial circuits 602-1 to 602-6 included in the encoding circuit 101-1 are replaced with the partial circuits 802-1 to 802-6. By storing intermediate results of the XOR operations by the XOR circuits into the BRAMs in this way, a throughput is improved.

A decoding process will briefly be described. In the decoding process, a process of reconstructing a lost block from received encoded blocks may be executed by utilizing the same circuit as the encoding circuit. However, the number of BRAMs disposed in an input unit of a decoding circuit is at most the number of column vectors of the encoding matrix. The data input to the AND circuit of the decoding circuit is not a column vector of the encoding matrix and is a vector for decoding. If the number of the lost blocks is a small number such as one or two, the decoding circuit preliminarily calculates and stores a decoding vector into a storage unit. As a result, the decoding circuit may acquire the decoding vector from the storage unit as in the case of table reference, resulting in a higher speed. If the number of lost blocks is large, the decoding circuit dynamically calculates and obtains the decoding vector according to an algorithm such as Gaussian elimination. This takes time because of the dynamic calculation.

Based on the above, a generation process of circuit information representative of the encoding circuit 101 by the design support apparatus 100 will be described in detail. Although the design support apparatus 100 is, for example, a user terminal apparatus in this description, the design support apparatus 100 may be the system 400 described above.

(Example of Hardware Configuration of Design Support Apparatus 100)

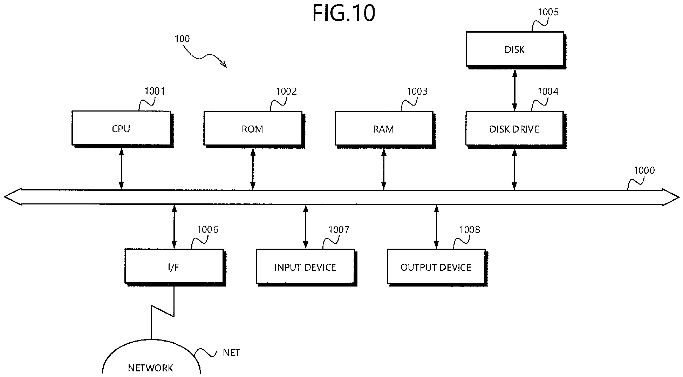

FIG. 10 is a block diagram of an example of hardware configuration of the design support apparatus according to the embodiment. In FIG. 10, the design support apparatus 100 has a central process unit (CPU) 1001, read-only memory (ROM) 1002, RAM 1003, a disk drive 1004, and a disk 1005. The design support apparatus 100 further has an interface (I/F) 1006, an input device 1007, and an output device 1008. The respective components are connected by a bus 1000.

Here, the CPU 1001 governs overall control of the design support apparatus 100. The ROM 1002 stores programs such as a boot program. The RAM 1003 is used as a work area of the CPU 1001. The disk drive 1004, under the control of the CPU 1001, controls the reading and writing of data with respect to the disk 1005. The disk 1005 stores data written thereto under the control of the disk drive 1004. The disk 1005 may be a magnetic disk, an optical disk, or the like.

The I/F 1006 is connected through a communications line to a network NET such as a local area network (LAN), a wide area network (WAN), and the Internet, and is connected to other computers via the network NET. The I/F 1006 administers an internal interface with the network NET and controls the input and output of data from an external device. The I/F 1006 may be a modem, a LAN adapter, or the like.

The input device 1007 is an interface that inputs various types of data by user operation of a keyboard, a mouse, a touch panel, and the like. The input device 1007 may take in images and moving pictures from a camera. The input device 1007 may further take in sound from a microphone. The output device 1008 is an interface that outputs data by an instruction from the CPU 1001. The output device 1008 may be a display, a printer, or the like.

(Example of Functional Configuration of Design Support Apparatus 100)

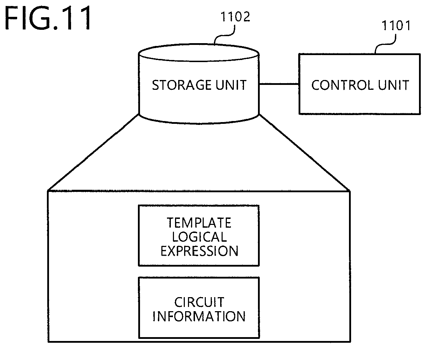

FIG. 11 is a block diagram of an example of a functional configuration of the design support apparatus. The design support apparatus 100 has a control unit 1101 and a storage unit 1102. The storage unit 1102 is implemented by the RAM 1003 and the disk 1005, for example. A process of the control unit 1101 is coded in a design support program stored in a storage device accessible by the CPU 1001. The CPU 1001 reads the design support program from the storage device to execute a process coded in the design support program, whereby a process of the control unit 1101 is thereby implemented. Process results of the control unit 1101 are stored to the storage unit 1102, for example.

The storage unit 1102 stores, for example, circuit information representative of each of the partial circuits 601-1 to 601-8 as template circuit information. The storage unit 1102 also stores a template expression described later.

The control unit 1101 acquires an encoding matrix and an acceleration number. With regard to a form of acquisition, the encoding matrix and the acceleration number may be acquired by reading the encoding matrix and the acceleration number stored in a storage device such as the RAM 1003 and the disk 1005 or may be acquired from a user through the input device 1007, etc. Accelerated execution means overlapping a second processing with a first processing. An increase in amount of overlap corresponds to a reduction in an execution start interval. The acceleration number indicates an amount of overlap.

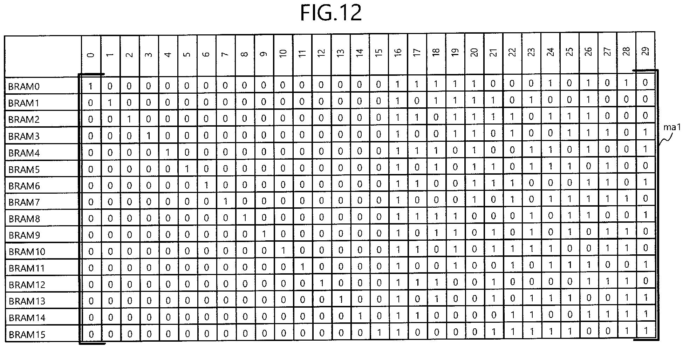

FIG. 12 is an explanatory diagram of an encoding matrix example. The lines of the encoding matrix ma1 correspond to divided blocks. The columns of the encoding matrix ma1 correspond to the order of the encoded blocks to be transmitted. The column vectors represent for which block an XOR operation is performed. For example, since the blocks are directly output in the RPS encoding process, the lines sequentially have a value of one in the 0th to 15th columns of the encoding matrix ma1. As a result, the blocks [0] to [15] acquired by dividing the 16-[KB] data are sequentially transmitted according to the first to 15th columns.

The 16th and subsequent columns of the encoding matrix ma1 have information set such that redundant data may be created. For example, since all the components are set to one in the 16th column depicted in FIG. 12, the block of the 16th transmission is data acquired by performing the XOR operation for each word of the data from the BRAM 0 to BRAM 15. The block of the 17th transmission is data acquired by performing the XOR operation for each word of the data of the BRAMs 0, 2, 4, 6, 8, 10, 12, and 14. Although the size of the encoding matrix ma1 is 16 lines and 30 columns for simplification of description in the example of FIG. 12, the size is not particularly limited.

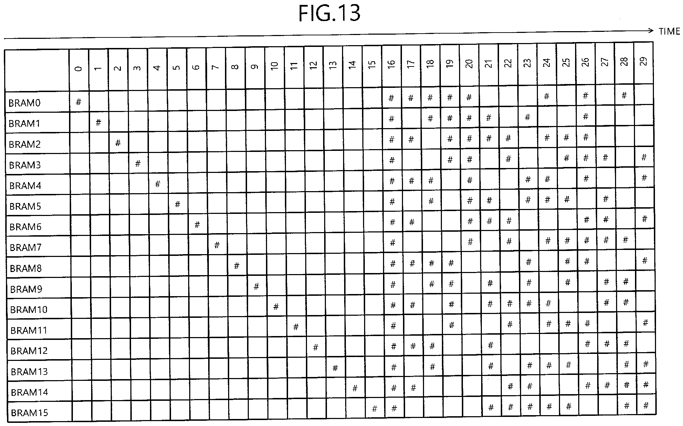

FIG. 13 is an explanatory diagram (part 1) of an access timing example when the acceleration number is zero. In this and subsequent access timing diagrams, "#" indicates a correspondence relation between the blocks referred to by the multiple XOR circuits and the BRAMs 0 to 15 storing the input blocks. When the acceleration number is zero, the encoding circuit 101 described above is directly utilized.

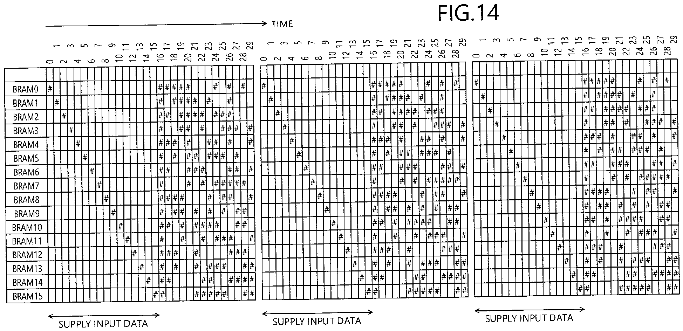

FIG. 14 is an explanatory diagram (part 2) of an access timing example when the acceleration number is zero. After the block 29 is output, new 16-[KB] data is written into the BRAMs 0 to 15. While the encoding circuit 101 is calculating the blocks for the redundant data, new blocks cannot be supplied to the BRAMs 0 to 15. Therefore, the throughput is reduced when the acceleration number is zero, and the throughput is improved by increasing the acceleration number.

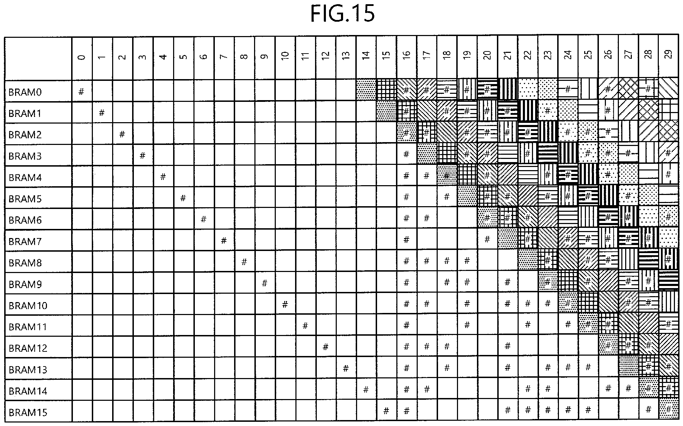

FIG. 15 is an explanatory diagram of a BRAM distribution example in which data is overwritten when supply of input blocks is accelerated. In the example of FIG. 15, since the data of the BRAMs with "#" is utilized for creation of the blocks in the same way even if the process is advanced by 1 to 16 cycles, the encoding process for creation of the blocks may not be executed normally.

Therefore, the control unit 1101 generates circuit information representative of the encoding circuit 101 provided with the BRAMS as in the partial circuits 801 and the partial circuits 802 described above so that the encoding process is normally executed even when being accelerated.

For example, based on the acceleration number, the control unit 1101 identifies a combination of the data erased due to acceleration and the timing of erasure. This combination can be represented by the i-th line and the j-th column. For example, based on the acceleration number, the control unit 1101 may color positions of data to be erased due to acceleration among the positions of data in the access timing diagram so as to identify the combinations. For each of the identified combinations, the control unit 1101 determines whether a component corresponding to the identified combination is 1 in the encoding matrix ma1.

If none of the identified combinations has a component of 1 corresponding to the combination, the control unit 1101 determines that the encoding process can be executed by the encoding circuit 101-1. On the other hand, if none of the identified combinations has a component of 1 corresponding to the combination, the control unit 1101 determines that the encoding process cannot be executed by the encoding circuit 101-1.

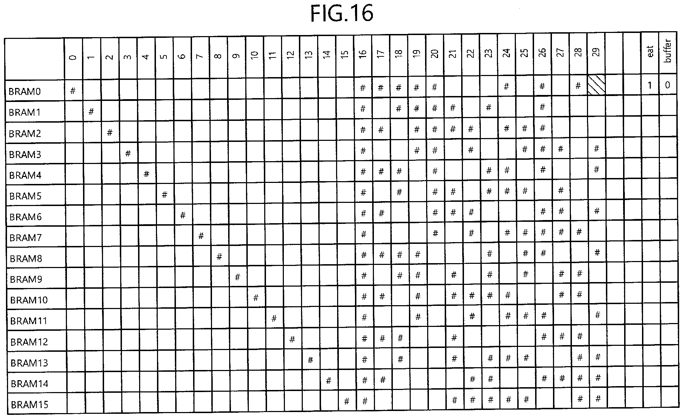

FIG. 16 is an explanatory diagram of an access timing example when the acceleration number is 1. When the acceleration number is 1, the supply of the input blocks to the BRAMs 0 to 15 is advanced by one cycle. In this case, the data of the BRAM 0 is overwritten and erased at the timing corresponding to the column vector 29. In the example of FIG. 16, since no XOR operation is performed for the data of BRAM 0 in creation of the encoded block 29, the encoding process is executed normally by the encoding circuit 101-1. The control unit 1101 determines that the acceleration can be achieved without modifying the encoding circuit 101-1 when the acceleration number is 1.

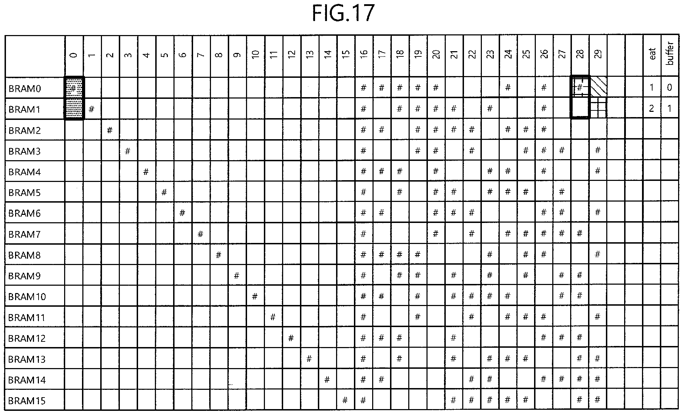

FIG. 17 is an explanatory diagram of an access timing example when the acceleration number is 2. When the acceleration number is 2, the supply of the input blocks to the BRAMs 0 to 15 is advanced by two cycles. When the acceleration number is 2, the data of the BRAM 0 is overwritten and erased at the timing corresponding to the column vector 28 and, since the data of the BRAM 0 is utilized, the encoding process is not executed normally by the encoding circuit 101-1. Additionally, when the acceleration number is 2, the data of the BRAMs 0 and 1 are overwritten and erased at the timing corresponding to the column vector 29 and, since the data of the BRAMs 0 and 1 are not utilized, the encoding process is executed normally by the encoding circuit 101-1. Therefore, the control unit 1101 determines that the acceleration cannot be achieved without modifying the encoding circuit 101-1 when the acceleration number is 2.

However, in the example of FIG. 17, the XOR operation utilizing the data of the BRAM 0 is performed at the time of creation of the encoded block 0 as is the case with the time of creation of the encoded block 28. Therefore, storage of an operation result of the XOR operation utilizing the data of the BRAM 0 enables the operation result to be diverted for use in the creation of the encoded block 28.

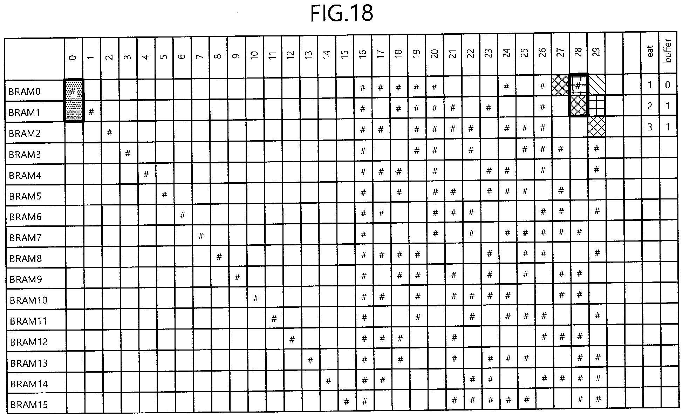

FIG. 18 is an explanatory diagram of an access timing example when the acceleration number is 3. When the acceleration number is 3, the supply of the input blocks to the BRAMs 0 to 15 is advanced by 3 cycles. When the acceleration number is 3, the data of the BRAM 0 is overwritten and erased at the timing corresponding to the column vector 27 and, since the data of the BRAM 0 is not utilized, the encoding process is executed normally by the encoding circuit 101-1. Additionally, when the acceleration number is 3, the data of the BRAMs 0 and 1 are overwritten and erased at the timing corresponding to the column vector 28 and, since the data of the BRAM 0 is utilized, the encoding process is not executed normally by the encoding circuit 101-1. Additionally, when the acceleration number is 3, the data of the BRAMs 0 to 2 are overwritten and erased at the timing corresponding to the column vector 29 and, since the data of the BRAMs 0 to 2 are not utilized, the encoding process is executed normally by the encoding circuit 101-1. Therefore, the control unit 1101 determines that the acceleration cannot be achieved without modifying the encoding circuit 101-1 when the acceleration number is 2.

However, in the example of FIG. 18, the XOR operation utilizing the data of the BRAM 0 is performed at the timing corresponding to the column vector 0 as is the case with the timing corresponding to the column vector 28. Therefore, storage of an operation result of the XOR operation utilizing the data of the BRAM 0, at the timing corresponding to the column vector 0 enables the operation result to be diverted for use at the timing corresponding to the column vector 28.

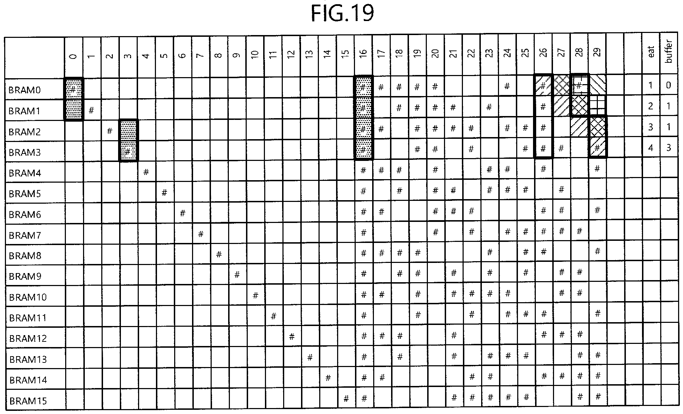

FIG. 19 is an explanatory diagram of an access timing example when the acceleration number is 4. When the acceleration number is 4, the supply of the input blocks to the BRAMs 0 to 15 is advanced by 4 cycles. When the acceleration number is 4, the data of the BRAM 0 is overwritten and erased at the timing corresponding to the column vector 26 and, since the data of the BRAM 0 is utilized, the encoding process is not executed normally by the encoding circuit 101-1. Additionally, when the acceleration number is 4, the data of the BRAMs 0 and 1 are overwritten and erased at the timing corresponding to the column vector 27 and, since the data of the BRAM 0 is not utilized, the encoding process is executed normally by the encoding circuit 101-1. Additionally, when the acceleration number is 4, the data of the BRAMs 0 to 2 are overwritten and erased at the timing corresponding to the column vector 28 and, since the data of the BRAM 1 is utilized, the encoding process is not executed normally by the encoding circuit 101-1. Additionally, when the acceleration number is 4, the data of the BRAMs 0 to 3 are overwritten and erased at the timing corresponding to the column vector 29 and, since the data of the BRAM 3 is utilized, the encoding process is not executed normally by the encoding circuit 101-1. Therefore, the control unit 1101 determines that the acceleration cannot be achieved without modifying the encoding circuit 101-1 when the acceleration number is 4.

However, in the example of FIG. 19, the XOR operation utilizing the data of the BRAMs 0 to 3 is performed at the timing corresponding to the column vector 16 as is the case with the timing corresponding to the column vector 26. Storage of an operation result of the XOR operation utilizing the data of the BRAMs 0 to 3, at the timing corresponding to the column vector 16 enables the operation result to be diverted for use at the timing corresponding to the column vector 26. In the example of FIG. 19, the XOR operation utilizing the data of the BRAM 0 is performed at the timing corresponding to the column vector 0 as is the case with the timing corresponding to the column vector 28. Therefore, storage of an operation result of the XOR operation utilizing the data of the BRAM 0 enables the operation result to be diverted for use at the timing corresponding to the column vector 28. In the example of FIG. 19, the XOR operation utilizing the data of the BRAM 3 is performed at the timing corresponding to the column vector 3 as is the case with the timing corresponding to the column vector 29. Storage an operation result of the XOR operation utilizing the data of the BRAM 3, at the timing corresponding to the column vector 3 enables the operation result to be diverted for use at the timing corresponding to the column vector 29.

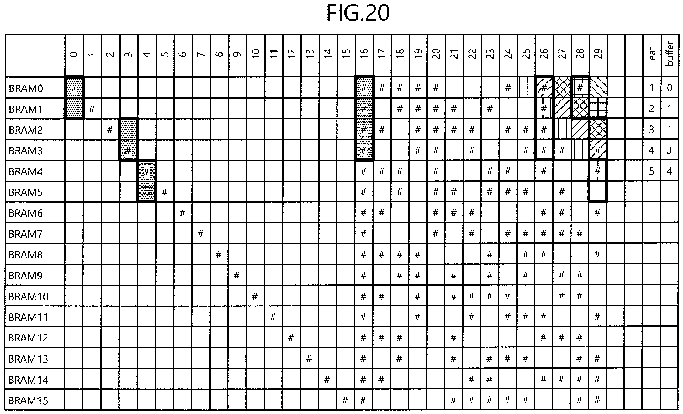

FIG. 20 is an explanatory diagram of an access timing example when the acceleration number is 5. When the acceleration number is 5, the supply of the input blocks to the BRAMs 0 to 15 is advanced by 5 cycles. When the acceleration number is 5, the data of the BRAM 0 is overwritten and erased at the timing corresponding to the column vector 25; however, since the data of the BRAM 0 is not utilized, the encoding process is executed normally by the encoding circuit 101-1. Additionally, when the acceleration number is 5, the data of the BRAMs 0 and 1 are overwritten and erased at the timing corresponding to the column vector 26 and, since the data of the BRAMs 0 and 2 are utilized, the encoding process is not executed normally by the encoding circuit 101-1.

Additionally, when the acceleration number is 5, the data of the BRAMs 0 to 2 are overwritten and erased at the timing corresponding to the column vector 27 and, since the data of the BRAMs 0 to 2 are not utilized, the encoding process is executed normally by the encoding circuit 101-1. Additionally, when the acceleration number is 5, the data of the BRAMs 0 to 3 are overwritten and erased at the timing corresponding to the column vector 28 and, since the data of the BRAM 0 is utilized, the encoding process is not executed normally by the encoding circuit 101-1.

Additionally, when the acceleration number is 5, the data of the BRAMs 0 to 4 are overwritten and erased at the timing corresponding to the column vector 29 and, since the data of the BRAMs 3 and 4 are utilized, the encoding process is not executed normally by the encoding circuit 101-1. Therefore, the control unit 1101 determines that the acceleration cannot be achieved without modifying the encoding circuit 101-1 when the acceleration number is 5.

However, in the example of FIG. 20, the XOR operation utilizing the data of the BRAMs 0 to 3 is performed at the timing corresponding to the column vector 16 as is the case with the timing corresponding to the column vector 26.

Storage of an operation result of the XOR operation utilizing the data of the BRAMs 0 to 3, at the timing corresponding to the column vector 16 enables the operation result to be diverted for use at the timing corresponding to the column vector 26.

In the example of FIG. 20, the XOR operation utilizing the data of the BRAM 0 is performed at the timing corresponding to the column vector 0 as is the case with the timing corresponding to the column vector 28. Therefore, storage of an operation result of the XOR operation utilizing the data of the BRAM 0 enables the operation result to be diverted for use at the timing corresponding to the column vector 28. In the example of FIG. 20, the XOR operation utilizing the data of the BRAM 3 is performed at the timing corresponding to the column vector 3 as is the case with the timing corresponding to the column vector 29. Storage of an operation result of the XOR operation utilizing the data of the BRAM 3, at the timing corresponding to the column vector 3 enables the operation result to be diverted for use at the timing corresponding to the column vector 29. The XOR operation utilizing the data of the BRAM 4 is performed at the timing corresponding to the column vector 4 as is the case with the timing corresponding to the column vector 29.

Therefore, an operation result of the XOR operation utilizing the data of the BRAM 3 is stored at the timing corresponding to the column vector 3. An operation result of the XOR operation utilizing the data of the BRAM 4 is stored at the timing corresponding to the column vector 4. As a result, the operation results may be diverted for use at the timing corresponding to the column vector 29.

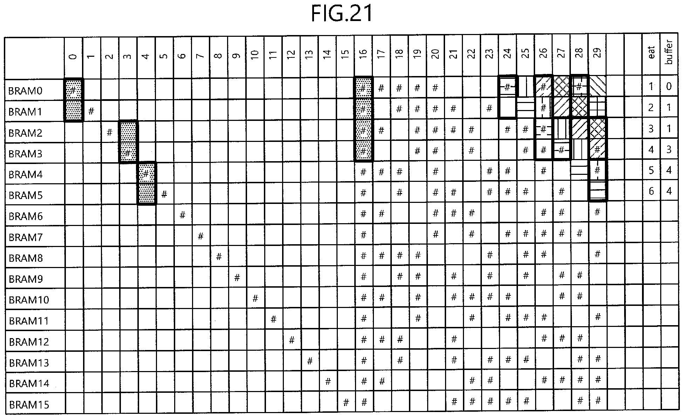

FIG. 21 is an explanatory diagram of an access timing example when the acceleration number is 6. When the acceleration number is 6, the supply of the input blocks to the BRAMs 0 to 15 is advanced by 6 cycles. When the acceleration number is 6, the data of the BRAM 0 is overwritten and erased at the timing corresponding to the column vector 24 and, since a reference is made to the data of the BRAM 0, the encoding process is not executed normally by the encoding circuit 101-1. Additionally, when the acceleration number is 6, the data of the BRAMs 0 and 1 are overwritten and erased at the timing corresponding to the column vector 25. However, since the data of the BRAMs 0 and 1 are not utilized, the encoding process is executed normally by the encoding circuit 101-1. Additionally, when the acceleration number is 6, the data of the BRAMs 0 to 2 are overwritten and erased at the timing corresponding to the column vector 26 and, since the data of the BRAMs 0 to 2 are utilized, the encoding process is not executed normally by the encoding circuit 101-1.

Additionally, when the acceleration number is 6, the data of the BRAMs 0 to 3 are overwritten and erased at the timing corresponding to the column vector 27 and, since the data of the BRAM 3 is utilized, the encoding process is not executed normally by the encoding circuit 101-1. Additionally, when the acceleration number is 6, the data of the BRAMs 0 to 4 are overwritten and erased at the timing corresponding to the column vector 28 and, since the data of the BRAM 0 is utilized, the encoding process is not executed normally by the encoding circuit 101-1. Additionally, when the acceleration number is 6, the data of the BRAMs 0 to 5 are overwritten and erased at the timing corresponding to the column vector 29. Since the data of the BRAMs 3 and 4 are utilized, the encoding process is not executed normally by the encoding circuit 101-1. Therefore, the control unit 1101 determines that the acceleration cannot be achieved without modifying the encoding circuit 101-1 when the acceleration number is 6.

However, in the example of FIG. 21, the XOR operation utilizing the data of the BRAM 0 is performed at the timing corresponding to the column vector 0 as is the case with the timing corresponding to the column vector 24. Storage of an operation result of the XOR operation utilizing the data of the BRAM 0, at the timing corresponding to the column vector 0 enables the operation result to be diverted for use at the timing corresponding to the column vector 24.

In the example of FIG. 21, the XOR operation utilizing the data of the BRAMs 0 to 3 is performed at the timing corresponding to the column vector 16 as is the case with the timing corresponding to the column vector 26. Storage of an operation result of the XOR operation utilizing the data of the BRAMs 0 to 3, at the timing corresponding to the column vector 16 enables the operation result to be diverted for use at the timing corresponding to the column vector 26.

In the example of FIG. 21, the XOR operation utilizing the data of the BRAM 0 is performed at the timing corresponding to the column vector 0 as is the case with the timing corresponding to the column vector 28. Therefore, storage of an operation result of the XOR operation utilizing the data of the BRAM 0 enables the operation result to be diverted for use at the timing corresponding to the column vector 28. In the example of FIG. 21, the XOR operation utilizing the data of the BRAM 3 is performed at the timing corresponding to the column vector 3 as is the case with the timing corresponding to the column vector 29. Additionally, the XOR operation utilizing the data of the BRAM 4 is performed at the timing corresponding to the column vector 4 as is the case with the timing corresponding to the column vector 29.

Therefore, an operation result of the XOR operation utilizing the data of the BRAM 3 is stored at the timing corresponding to the column vector 3. An operation result of the XOR operation utilizing the data of the BRAM 4 is stored at the timing corresponding to the column vector 4. As a result, the operation results may be diverted for use at the timing corresponding to the column vector 29.

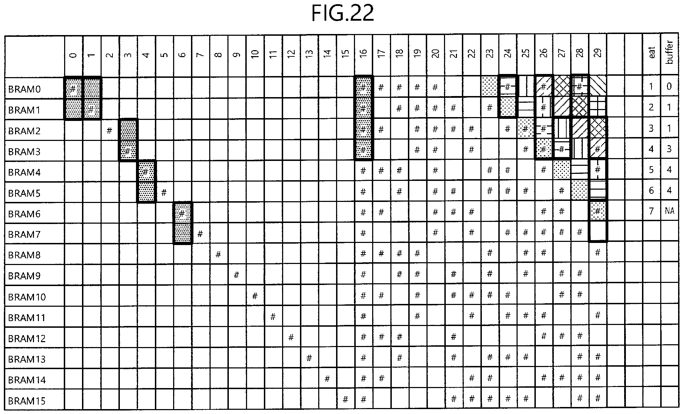

FIG. 22 is an explanatory diagram of an access timing example when the acceleration number is 7. When the acceleration number is 7, the supply of the input blocks to the BRAMs 0 to 15 is advanced by 7 cycles. When the acceleration number is 7, the data of the BRAM 0 is overwritten and erased at the timing corresponding to the column vector 23; however, since the data of the BRAM 0 is not utilized, the encoding process is executed normally by the encoding circuit 101-1. Additionally, when the acceleration number is 7, the data of the BRAMs 0 and 1 are overwritten and erased at the timing corresponding to the column vector 24. However, since the data of the BRAMs 0 and 1 are utilized, the encoding process is not executed normally by the encoding circuit 101-1. Additionally, when the acceleration number is 7, the data of the BRAMs 0 to 2 are overwritten and erased at the timing corresponding to the column vector 25 and, since the data of the BRAMs 0 and 3 are utilized, the encoding process is not executed normally by the encoding circuit 101-1. Additionally, when the acceleration number is 7, the data of the BRAMs 0 to 3 are overwritten and erased at the timing corresponding to the column vector 26 and, since the data of the BRAMs 0 to 3 are utilized, the encoding process is not executed normally by the encoding circuit 101-1.

Additionally, when the acceleration number is 7, the data of the BRAMs 0 to 4 are overwritten and erased at the timing corresponding to the column vector 27 and, since the data of the BRAM 3 is utilized, the encoding process is not executed normally by the encoding circuit 101-1. Additionally, when the acceleration number is 7, the data of the BRAMs 0 to 5 are overwritten and erased at the timing corresponding to the column vector 28. Since the data of the BRAM 0 is utilized, the encoding process is not executed normally by the encoding circuit 101-1. Additionally, when the acceleration number is 7, the data of the BRAMs 0 to 6 are overwritten and erased at the timing corresponding to the column vector 29. Since the data of the BRAMs 4 and 6 are utilized, the encoding process is not executed normally by the encoding circuit 101-1. Therefore, the control unit 1101 determines that the acceleration cannot be achieved without modifying the encoding circuit 101-1 when the acceleration number is 7.

However, in the example of FIG. 22, the XOR operation utilizing the data of the BRAM 0 is performed at the timing corresponding to the column vector 0 as is the case with the timing corresponding to the column vector 24. Storage of an operation result of the XOR operation utilizing the data of the BRAM 0, at the timing corresponding to the column vector 0 enables the operation result to be diverted for use at the timing corresponding to the column vector 24.

In the example of FIG. 22, the XOR operation utilizing the data of the BRAMs 2 and 3 is performed at the timing corresponding to the column vector 16 as is the case with the timing corresponding to the column vector 25. An operation result of the XOR operation utilizing the data of the BRAMs 2 and 3 is stored at the timing corresponding to the column vector 16. As a result, the operation result may be diverted for use at the timing corresponding to the column vector 25. However, although the reason is described later, the operation result may not necessarily be diverted because of a property determined by the BRAMs disposed in the circuit of FIG. 9.

In the example of FIG. 22, the XOR operation utilizing the data of the BRAMs 0 to 3 is performed at the timing corresponding to the column vector 16 as is the case with the timing corresponding to the column vector 26. Storage of an operation result of the XOR operation utilizing the data of the BRAMs 0 to 3, at the timing corresponding to the column vector 16 enables the operation result to be diverted for use at the timing corresponding to the column vector 26.

In the example of FIG. 22, the XOR operation utilizing the data of the BRAM 3 is performed at the timing corresponding to the column vector 3 as is the case with the timing corresponding to the column vector 27. Storage of an operation result of the XOR operation utilizing the data of the BRAM 3, at the timing corresponding to the column vector 3 enables the operation result to be diverted for use at the timing corresponding to the column vector 27.

In the example of FIG. 22, the XOR operation utilizing the data of the BRAM 0 is performed at the timing corresponding to the column vector 0 as is the case with the timing corresponding to the column vector 28. Therefore, storage of an operation result of the XOR operation utilizing the data of the BRAM 0 enables the operation result to be diverted for use at the timing corresponding to the column vector 28.

In the example of FIG. 22, the XOR operation utilizing the data of the BRAM 3 is performed at the timing corresponding to the column vector 3 as is the case with the timing corresponding to the column vector 29. Additionally, the XOR operation utilizing the data of the BRAM 4 is performed at the timing corresponding to the column vector 4 as is the case with the timing corresponding to the column vector 29. Additionally, the XOR operation of only the data of the BRAM 6 is performed at the timing corresponding to the column vector 6 as is the case with the timing corresponding to the column vector 29. An operation result of the XOR operation utilizing the data of the BRAM 3 is stored at the timing corresponding to the column vector 3 and an operation result of the XOR operation utilizing the data of the BRAM 4 is stored at the timing corresponding to the column vector 4. As a result, the operation results may be diverted for use at the timing corresponding to the column vector 29.

However, at the timing corresponding to the column vector 3, an operation result of "(data of BRAM 2 & column vector [2]) XOR (data of BRAM 3 & column vector [3])" is stored in the BRAM. Subsequently, when the operation result is stored at the timing corresponding to the column vector 16, the operation result at the timing corresponding to the column vector 3 is overwritten. Therefore, the control unit 1101 determines that the acceleration cannot be achieved when the acceleration number is seven.

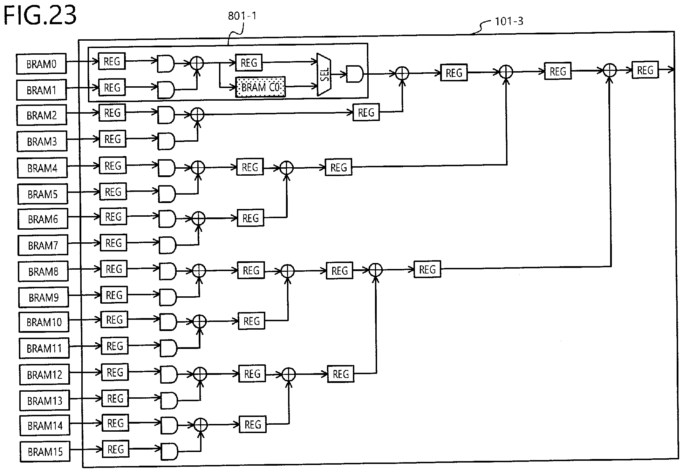

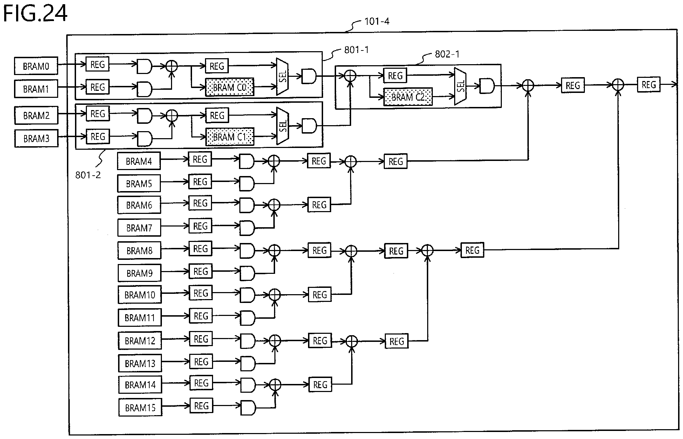

As described with reference to FIGs. 16 to 22, even if the encoding circuit 101-1 cannot directly be diverted, the accelerated execution may be enabled by storing an operation result of any of the XOR operations into the BRAM. For example, FIG. 23 depicts an example of the encoding circuit 101 when the acceleration number is 2 or 3, and FIG. 24 depicts an example of the encoding circuit 101 when the acceleration number is 4.

FIG. 23 is an explanatory diagram of an example of the encoding circuit 101 when the acceleration number is 2 or 3. An encoding circuit 101-3 is a circuit having the partial circuit 601-1 replaced with the partial circuit 801-1 in the encoding circuit 101-1. When the acceleration number is 2 or 3, an operation result of "(data of BRAM 0 & column vector 0) XOR (data of BRAM 1 & column vector 1)" is stored in the BRAM at the timing corresponding to the column vector 0 in the encoding circuit 101-3. In the encoding circuit 101-3, the operation result stored in the BRAM is selected by the selection circuit and output to the subsequent stage at the timing corresponding to the column vector 28.

FIG. 24 is an explanatory diagram of an example of the encoding circuit 101 when the acceleration number is 4. An encoding circuit 101-4 is a circuit having the partial circuit 601-1 replaced with the partial circuit 801-1, the partial circuit 601-2 replaced with the partial circuit 801-2, and the partial circuit 602-1 replaced with the partial circuit 802-1 in the encoding circuit 101-1.

When the acceleration number is 4, an operation result of "(data of BRAM 0 & column vector [0]) XOR (data of BRAM 1 & column vector [1])" is stored in the BRAM at the timing corresponding to the column vector 0 in the encoding circuit 101-4. Additionally, an operation result of "(data of BRAM 2 & column vector [2]) XOR (data of BRAM 3 & column vector [3])" is stored in the BRAM at the timing corresponding to the column vector 3 in the encoding circuit 101-4. Additionally, an operation result of "{(data of BRAM 0 & column vector [0]) XOR (data of BRAM 1 & column vector [1])} XOR {(data of BRAM 2 & column vector [2]) XOR (data of BRAM 3 & column vector [3])}" is stored in the BRAM at the timing corresponding to the column vector 16 in the encoding circuit 101-4.

A method of determining a position of an added BRAM will be described in detail. For example, the control unit 1101 determines which circuit is replaced with the partial circuit 801 or the partial circuit 802 among the partial circuits 601 and partial circuits 602 included in the encoding circuit 101-1.

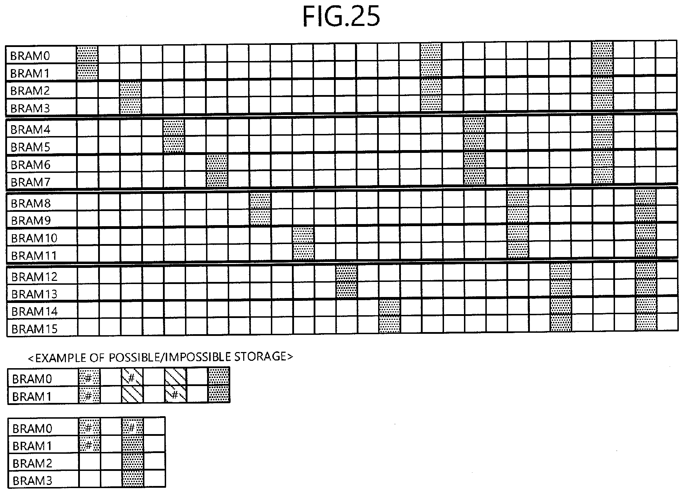

FIG. 25 is an explanatory diagram of a position example of the BRAMs. Since operation results of XOR operations are retained by the BRAMs, the encoding circuit 101-2 can store the operation results at positions as depicted in FIG. 25 in the BRAMs.

As depicted in <example of possible/impossible storage> of FIG. 25, a BRAM disposed at an output position of (data of BRAM 0) XOR (data of BRAM 1) is taken as an example. For example, if it is determined that the operation result of (data of BRAM 0) XOR (data of BRAM 1) is stored in this BRAM, the data of the BRAM 0 or the data of the BRAM 1 cannot be stored. However, the data of the BRAM 0 can be stored by utilizing a BRAM disposed at the output position of {(data of BRAM 0) XOR (data of BRAM 1)} XOR {(data of BRAM 2) XOR (data of BRAM 3}. Additionally, since the XOR operation can be performed by using the stored data, data can actually be stored in multiple combinations.

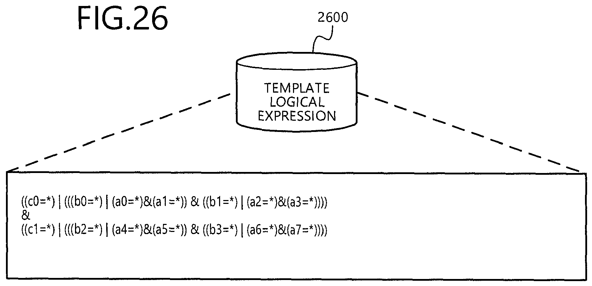

FIG. 26 is an explanatory diagram of a template logical expression. The control unit 1101 acquires a template logical expression 2600. For the template logical expression 2600 depicted in FIG. 26, the case of 16 input blocks is taken as an example. In other words, the encoding matrix ma1 with 16 lines is taken as an example.

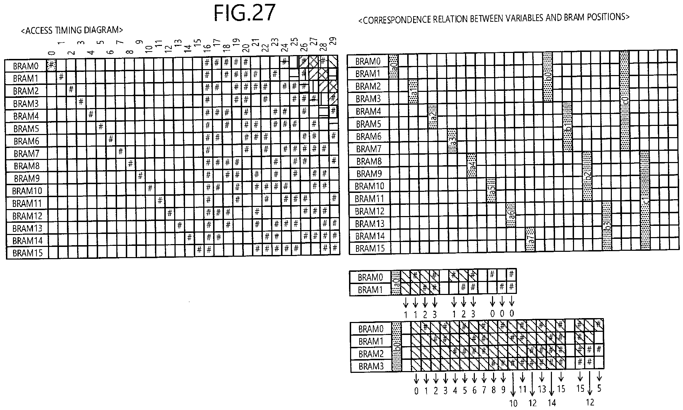

FIG. 27 is an explanatory diagram of a correspondence relation between variables and BRAM positions. For example, variables a0 to a7 included in the template logical expression 2600 indicate which data is stored in a BRAM capable of storing an output result of an XOR circuit on a first stage from the BRAMs storing the respective input blocks. For example, the variable a0 indicates which data is stored in the BRAM retaining an operation result of the XOR operation of the data of the BRAM 0 and the data of the BRAM 1. For example, variables b0 to b3 included in the template logical expression 2600 indicate which data is stored in a BRAM capable of storing an output result of an XOR circuit on a second stage from the BRAMs storing the respective input blocks. For example, the variable b0 indicates which data is stored in the BRAM retaining the operation result of the XOR operation performed by using an operation result of the XOR operation of the data of the BRAM 0 and the data of the BRAM 1 as well as an operation result of the XOR operation of the data of the BRAM 2 and the data of the BRAM 3. For example, variables c0 to c1 included in the template logical expression 2600 indicate which data is stored in a BRAM capable of storing an output result of an XOR circuit on a third stage from the BRAMs storing the respective input blocks. For example, the variable c0 indicates which data is stored in the BRAM retaining an operation result of the XOR operation performed by using an operation result of the XOR operation from the data of the BRAM 0 to the data of the BRAM 3 as well as an operation result of the XOR operation from the data of the BRAM 4 to the data of the BRAM 7. The variables a, b, and c can take values within ranges listed below.

$$0 \leq an(n=0 \text{ to } 7) \leq (2^2)-1=3$$

$$0 \leq bm(m=0 \text{ to } 3) \leq (2^4)-1=15$$

$$0 \leq cl(l=0 \text{ to } 1) \leq (2^8)-1=255$$

It is noted that denotes a power operator. However, taking b0 as an example, values such as b0=7 and b0=9 cannot be taken because the calculations are not actually performed by the encoding circuit 101-1. For example, a0=3 indicates that an operation result of (data of BRAM 0) XOR (data of BRAM 1) is stored in the BRAM. For example, a0=2 indicates that an operation result of (data of BRAM 0 and 0) XOR (data of BRAM 1 and 1) is stored in the BRAM. For example, a0=1 indicates that an operation result of (data of BRAM 0 and 1) XOR (data of BRAM 1 and 0) is stored in the BRAM.

Based on the acquired template logical expression 2600, the control unit 1101 obtains a logical expression for each of the columns subsequent to the number of blocks to be input in the encoding matrix ma1. In this example, the control unit 1101 obtains a logical expression for each of the columns 16 to 29. For example, the control unit 1101 performs the binary encoding by setting 1 at a position to which "#" is added in the lines BRAM x to BRAM y to which the variable corresponds in the access timing diagram described above. A binary-encoded numerical value is an element of a set of values that the variable can take. Taking the variable b0 as an example, the control unit 1101 performs the binary encoding by setting 1 at a position to which "#" is added in the lines BRAM 0 to BRAM 3 to which the variable b0 corresponds. The BRAM0 corresponds to the least significant bit and the BRAM 3 corresponds to the most significant bit. For example, the zeroth column is 0001; the first column is 0010, the second column is 0100; the third column is 1000; the fourth to 15th columns are 0000; the 16th, 19th, 20th, and 26th columns are 1111; the 17th column is 0101; and the 18th column is 0011. The variable b0 can take values {0001, 0010, 0100, 1000, 0000, 1111, 0101, 0011, ...}. In decimal numbers, {1, 2, 4, 8, 0, 15, 5, 3, ...} is the set of values that the variable b0 can take.

In this example, for example, the control unit 1101 obtains the logical expression for the 29th column. For c0, 01011000 (binary number)=88 (decimal number) is obtained.
For b0, 1000 (binary number)=8(decimal number)is obtained. For b1, 0101(binary number)=5(decimal number)is obtained. For a0, 00(binary number)=0(decimal number)is obtained. For a1, 10(binary number)=2(decimal number)is obtained. For a2, 01(binary number)=1(decimal number)is obtained.

The control unit 1101 substitutes the above numbers into the template logical expression 2600 to obtain the following expression.

$$((c0=88)\,|\,(((b0=8)\,|\,(a0=0)\,\&\,(a1=2))\,\&\,((b1=5)\,|\,(a2=1)\,\&\,(a3=0)$$
$$)))\,\&\,((c1=0)\,|\,(((b2=0)\,|\,(a4=0)\,\&\,(a5=0))\,\&\,((b3=0)\,|\,(a6=0)\,\&\,(a7=0)))$$
$$)$$

The logical expression can be simplified by defining that a term in the format of VARIABLE=0 is always "TRUE." The logical expression is simplified as follows:

$$((c0=88)\,|\,(((b0=8)\,|\,TRUE\,\&\,(a1=2))\,\&\,((b1=5)\,|\,(a2=1)\,\&\,TRUE)))\,\&\,(TRUE$$
$$|\,((TRUE\,|\,TRUE\,\&\,TRUE)\,\&\,(TRUE\,|\,TRUE\,\&\,TRUE)))$$

The expression is further simplified as follows:

$$((c0=88)\,|\,(((b0=8)\,|\,(a1=2))\,\&\,((b1=5)\,|\,(a2=1)\,\&\,TRUE)))\,\&\,(TRUE\,|\,((TR$$
$$UE\,|\,TRUE\,\&\,TRUE)))$$

The expression is further simplified as follows:

$$(c0=88)\,|\,(((b0=8)\,|\,(a1=2))\,\&\,((b1=5)\,|\,(a2=1)))$$

logical expression 29

In this way, the control unit 1101 obtains the logical expression 29 for the column 29.

The logical expression 29 indicates which BRAM can be utilized for compensating the data of the BRAM 3 and the BRAM 4 of which the input blocks are overwritten and erased when the encoded block 29 is generated.

The logical expression 29 is TRUE in the case of c0=88, for example, and 88 is 01011000 in binary notation, which means that the value of (data of BRAM 6) XOR (data of BRAM 4) XOR (data of BRAM 3) may be stored at a position of 1 when c0 is represented in binary notation.

For example, the control unit 1101 obtains a logical expression 28 for the 28th column as follows.

```
(c0=129)│(((b0=1)│(a0=1)&(a1=0))&((b1=8)│(a2=0)&(a3=0)
))
```

This expression is further simplified as follows:

```
(c0=129)│(((b0=1)│(a0=1)&(a1=0))&((b1=8)│TRUE))
(c0=129)│(b0=1)│(a0=1)          logical expression 28
```

For example, the control unit 1101 obtains a

```
(c0=232)│(((b0=8)│(a0=0)&(a1=2))&((b1=0)│(a2=0)&(a3=0)
))
```

This expression is further simplified as follows:

```
(c0=232)│(((b0=8)│TRUE&(a1=2))&(TRUE│TRUE))
```

By further simplification, logical expression 27 is obtained below.

```
(c0=232)│(b0=8)│(a1=2)          logical expression 27
```

For example, the control unit 1101 obtains a logical expression 26 for the 26th column as follows.

```
(c0=223)│(((b0=15)│(a0=3)&(a1=3))&((b1=0)│(a2=0)&(a3=0
))))
```

By further simplification, logical expression 26 is obtained below.

```
(c0=223)│(b0=15)│(a0=3)&(a1=3)          logical
expression 26
```

For example, the control unit 1101 obtains a logical expression 25 for the 25th column as follows.

```
((c0=0)│(((b0=12)│(a0=0)&(a1=0))&((b1=0)│(a2=0)&(a3=0)
)))          logical expression 25
```

For example, the control unit 1101 obtains a logical expression 24 for the 24th column as follows.

```
((c0=181)│(((b0=5)│(a0=1)&(a1=0))&((b1=0)│(a2=0)&(a3=0
)))))
```

By further simplification, logical expression 24 is obtained below.

$$(c0=181)\,|\,(b0=5)\,|\,(a0=1) \qquad\qquad \text{logical expression 24}$$

For example, for the 23rd column, the following is obtained.
TRUE logical expression 23

Subsequently, the control unit 1101 creates a logical expression X taking all the ANDs of the logical expressions for each column.

X=(logical expression 29) AND (logical expression 28) AND (logical expression 27) AND ...

$$X=((c0=88)\,|\,(((b0=8)\,|\,(a1=2))\,\&\,((b1=5)\,|\,(a2=1)))) \,\&$$
$$((c0=129)\,|\,(b0=1)\,|\,(a0=1))\,\&$$
$$((c0=232)\,|\,(b0=8)\,|\,(a1=2))\,\&$$
$$((c0=223)\,|\,(b0=15)\,|\,(a0=3)\,\&\,(a1=3))\,\&$$
$$((c0=181)\,|\,(b0=5)\,|\,(a0=1))$$

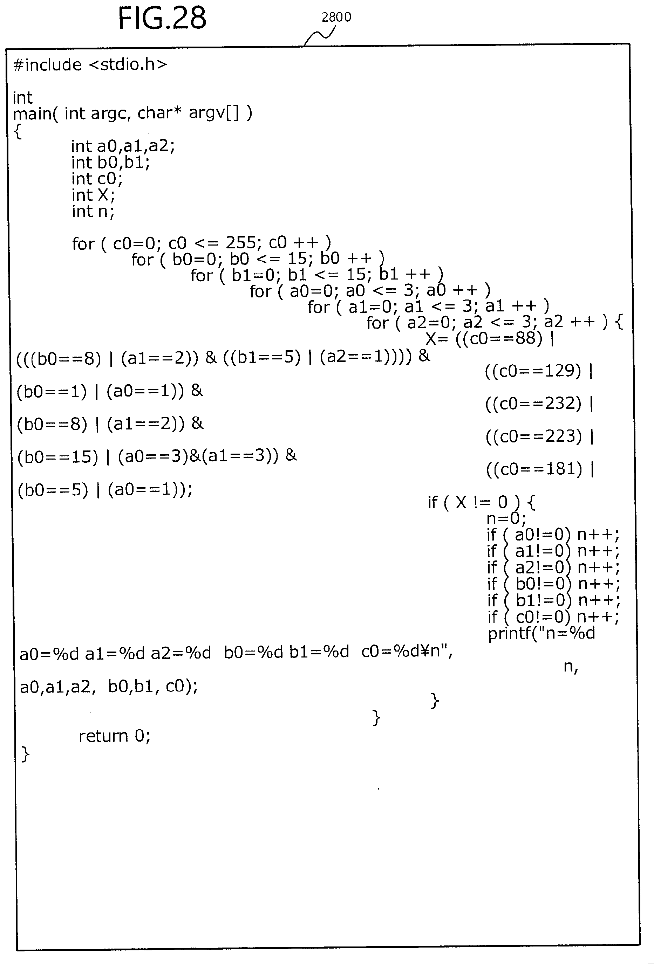

The control unit 1101 obtains assignments of integer values to a0, ..., a7, b0, ... b4, c0, c1 so as to set the created logical expression X to TRUE. The obtained solution is the solution to the BRAM assignment problem. By increasing the assignments having a value of zero, the number of BRAMs to be added can be reduced. For example, the BRAM assignment problem can efficiently be solved by using software called a SAT solver (e.g., "The miniSat Page, [online], [retrieved on December 6, 2013], Internet <http://minisat.se/>"). Alternatively, for example, the control unit 1101 may perform calculations by using all possible combinations as depicted in FIG. 28.

FIG. 28 is an explanatory diagram of an example of a program solving the BRAM assignment problem. For example, the CPU 1001 executes a program 2800 depicted in FIG. 28 to obtain the following results. The program 2800 is a portion of the design support program.

```
n=4  a0=1  a1=0  a2=0  b0=8  b1=5  ...  c0=223

n=4  a0=1  a1=0  a2=1  b0=8  b1=0  ...  c0=223

n=4  a0=1  a1=2  a2=0  b0=0  b1=5  c0=223

n=4  a0=1  a1=2  a2=0  b0=15  b1=0  c0=88

n=4  a0=1  a1=2  a2=0  b0=15  b1=5  c0=0

n=4  a0=1  a1=2  a2=0  b0=15  b1=5  c0=0

n=4  a0=1  a1=2  a2=1  b0=0  b1=0  c0=223

n=4  a0=1  a1=2  a2=1  b0=15  b1=0  c0=0
```

For example, the control unit 1101 utilizes the solution "a0=1 a1=2 a2=1 b0=15" to generate the circuit information representative of the encoding circuit 101 operating as follows.

The encoding circuit 101 stores the data of the BRAM 0 (=(data of BRAM 0 and 1) XOR (data of BRAM 1 and 0)) into the BRAM at the position indicted by the variable a0.

The encoding circuit 101 stores the data of the BRAM 3 into the BRAM at the position indicted by the variable a1.

The encoding circuit 101 stores the data of the BRAM 4 into the BRAM at the position indicted by the variable a2.

The encoding circuit 101 stores (data of BRAM 0) XOR (data of BRAM 1) XOR (data of BRAM 2) XOR (data of BRAM 3) into the BRAM at the position indicted by the variable b0.

Subsequently, the control unit 1101 identifies a timing of storage of data into the BRAM at the position indicted by each of the variables for the obtained solution. The control unit 1101 identifies the timing of storage of data among the timings corresponding to column vectors 0 to 23 before a block is overwritten due to the accelerated execution.

For example, in the case of the acceleration number of four, a0=1 is satisfied at the timing corresponding to each of the column vectors 0 and 17. In other words, this indicates that the operation result of (data of BRAM 0) XOR (data of BRAM 1) is stored at the timing corresponding to each of the column vectors 0 and 17. If multiple timings exist, the control unit 1101 may select any of the timings.

The timing of reading the data of the BRAM at a position indicated by each of the variables is within a period of overwriting of the input block. For example, the timing of reading a0=1 indicates reading at the timing corresponding to the column vector 24 and the timing corresponding to the column vector 28. For example, the timing of reading a1=2 indicates reading at the timing corresponding to the column vector 27 and the timing corresponding to the column vector 29.

For example, the timing of reading a2=1 indicates reading at the timing corresponding to the column vector 29. For example, the timing of reading b0=15 indicates reading at the timing corresponding to the column vector 26.

In the case of the acceleration number of four, the timing determination results of variables, storage timings, and reading timings are as follows.

| variables | storage timings | reading timings |
| --- | --- | --- |
| a0=1 | 0 | 24, 28 |
| a1=2 | 3 | 27, 29 |
| a2=1 | 4 | 29 |
| b0=15 | 16 | 26 |

The control unit 1101 generates circuit information representative of the encoding circuit 101 based on the BRAMs at positions indicated by the variables, the data to be stored in the BRAMs, and the timings obtained as described above. For example, the control unit 1101 generates the circuit information representative of the encoding circuit 101 provided with the partial circuit 801 or the partial circuit 802 if a value is set to a variable, and provided with the partial circuit 601 or the partial circuit 602 at a position indicated by the variable if no value is set to the variable.

Subsequently, the control unit 1101 generates circuit information representative of a control circuit generating a control signal. The control circuit enables a write enable signal at the storage timings so as to allow writing of data into the BRAMs. The control circuit disables the write enable signal at timings other than the storage timings so as not to allow writing of data into the BRAMs.

The control circuit enables a read selection signal at the reading timings so as to allow reading of data from the BRAMs. The control circuit disables the read selection signal at timings other than the read timings so as to output values from the XOR circuits.

From the timing determination results described above, the control unit 1101 may automatically generate circuit description described in a hardware description language such as Verilog-HDL. The control unit 1101 applies the obtained circuit description to a logic synthesis tool to obtain circuit information representative of the control circuit.

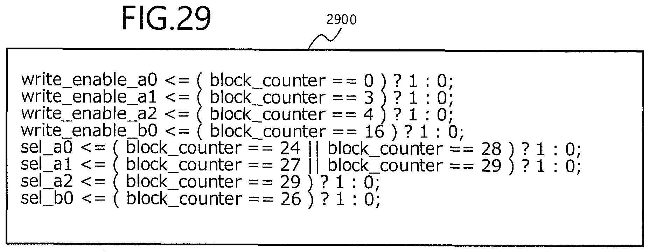

FIG. 29 is an explanatory diagram of an example of a circuit description to be generated. The circuit description 2900 has detailed descriptions of methods of determining values of the write enable signal and the read selection signal output from the control circuit, and operation of a block number counter.

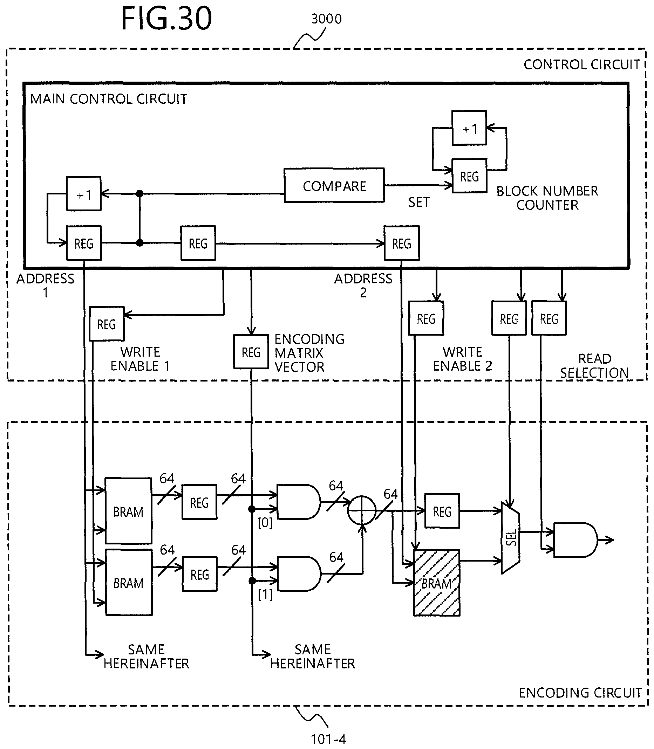

FIG. 30 is an explanatory diagram of the encoding circuit 101 and the control circuit controlling the encoding circuit 101. Signals input from a control circuit 3000 to an encoding circuit 101-4 and blocks included in the control circuit 3000 will briefly be described. An address 1 supplies an address value when a new block is written into a BRAM storing an input block or when data is read from the BRAM. The block number counter is a counter incrementing a block number when an encoding process is completed for one block and corresponds to a number of a column vector.

An address 2 supplies an address value when data is written into, or read from, a BRAM storing an operation result of an XOR operation. The address 2 has a value varying in synchronization with a counter of the address 1. The value varies with a delay corresponding to the number of stages of registers in the encoding circuit 101-4.

A write enable 2 is a control signal that has a value varying in synchronization with the block number counter and that is enabled only when a block is stored in a BRAM storing an operation result of an XOR operation. A read selection is a control signal of the selection circuit and is a control signal enabled only at the storage timing of storing a block into a BRAM storing an operation result of an XOR operation. The read selection has a value varying in synchronization with the block number counter.

The read selection is a control signal input to one input end of the AND circuit and is a signal for forcibly setting the output to zero. The read selection is utilized when one or both of values of the data of the BRAMs 0 and 1 are lost due to overwriting and it is desired to perform an XOR operation with the data of the BRAMs 0 and 1 set to zero, and is not used in the above example.

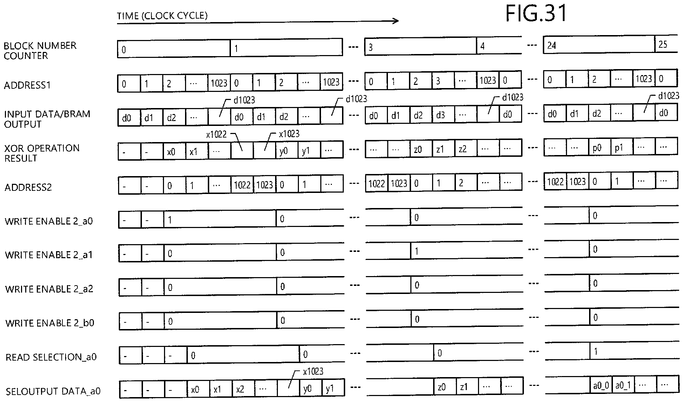

FIG. 31 is an explanatory diagram of an operation example of the circuit depicted in FIG. 30. As depicted in FIG. 31, when the block number counter has the value of zero, a write enable 2_a0 is one. When the block number counter has the value of three, a write enable 2_a1 is one. When the block number counter has the value of 24, a read selection_a0 is one.

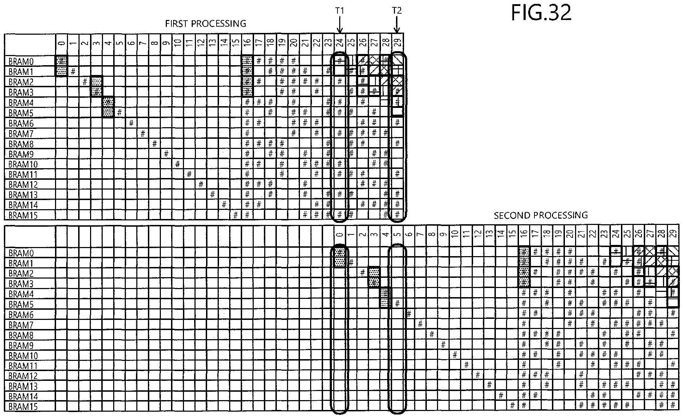

FIG. 32 is an explanatory diagram of an accelerated execution process example. During the period of execution of the accelerated execution process, output encoded data is doubled. At timing T1, an operation result of the XOR operation at the timing corresponding to the column vector 24 is output in the first processing, and an operation result of the XOR operation at the timing corresponding to the column vector 0 is output in the second processing. At timing T2, an operation result of the XOR operation at the timing corresponding to the column vector 29 is output in the first processing, and an operation result of the XOR operation at the timing corresponding to the column vector 5 is output in the second processing.

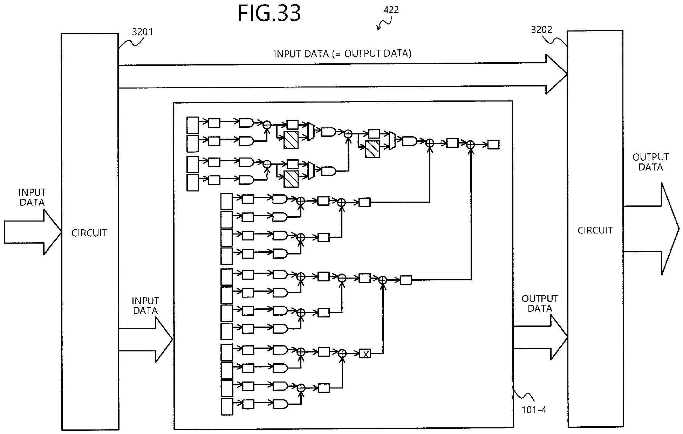

FIG. 33 is an explanatory diagram of an example of a circuit configuration for executing the accelerated execution process. In FIG. 33, a case of the acceleration number being four is taken as an example. The RPS hardware unit 422 has a circuit 3201, the encoding circuit 101-4, and a circuit 3202. The circuit 3201 directly sends the input blocks corresponding to N blocks from the top as output data during an accelerated execution period. The circuit 3202 receives encoded blocks through two routes and sequentially sends the encoded blocks to a process of the subsequent stage.

After acquiring the encoding matrix ma1, the control unit 1101 can reduce the number of BRAMs by interchanging the column vectors. Even if the column vectors of the encoding matrix ma1 are interchanged, the correction capability of the RPS encoding process is the same. Interchanging the column vectors is equal to interchanging the transmission orders of packets. Since the same packets are finally received on the reception side receiving the packets, the correction capability is the same. However, a difference may occur in a time until the correction can be made. For example, if the correction can be made when the 17th encoding data is received in the case of the original encoding matrix, and the column vector 17 is moved to the column vector 29 in the encoding matrix, the correction is made when the 29th encoded data is received.

FIG. 34 is an explanatory diagram of an example of interchanging column vectors of an encoding matrix. For example, the control unit 1101 counts the number of consecutive zeros from the first line for each of the column vectors after the (input block number)-th column in the encoding matrix ma1. Based on the encoding matrix ma1, the control unit 1101 generates an encoding matrix ma2 sorted in ascending order of the counting results. In the example of FIG. 34, the orders are changed in the column vectors 21 and later.

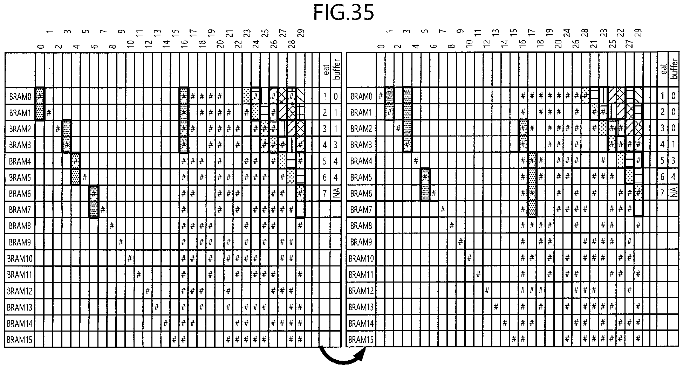

FIG. 35 is an explanatory diagram of an example of changing the number of BRAMs used according to interchanging of the column vectors. For example, the encoding matrix ma1 before the interchange has one added BRAM in the case of the acceleration number of three, and has four added BRAMs in the case of the acceleration number of five. On the other hand, the encoding matrix ma2 after the interchange has no added BRAM in the case of the acceleration number of three, and has three added BRAMs in the case of the acceleration number of five. As described above, by interchanging the column vectors, the number of the added BRAMs can be reduced.

(Example of Design Support Process Procedure by Design Support Apparatus 100)

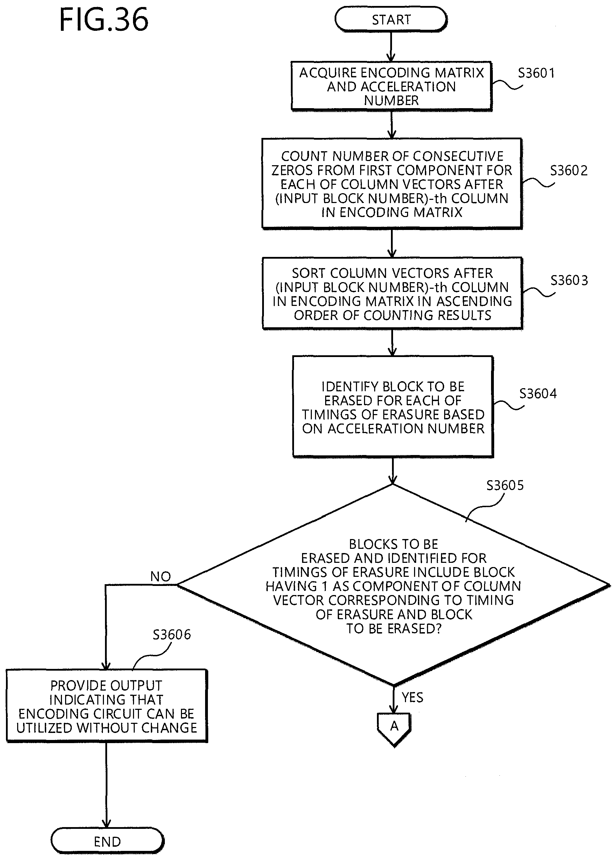

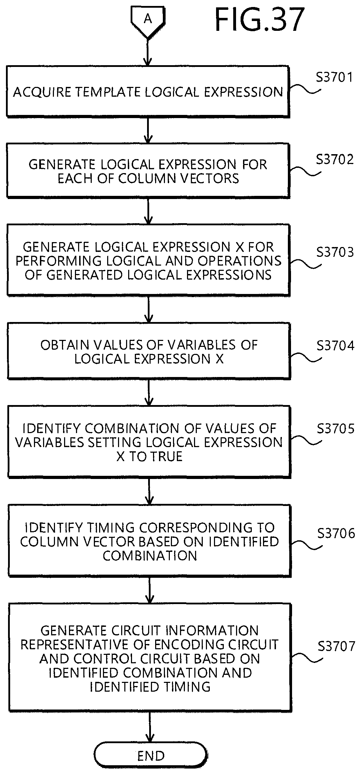

FIGs. 36 and 37 are flowcharts of an example of a support process procedure by the design support apparatus. First, the design support apparatus 100 acquires the encoding matrix and the acceleration number (step S3601). The design support apparatus 100 counts the number of consecutive zeros from a first component for each of the column vectors after the (input block number)-th column in the encoding matrix (step S3602). The design support apparatus 100 sorts the column vectors after the (input block number)-th column in the encoding matrix in ascending order of the counting results (step S3603).

Subsequently, the design support apparatus 100 identifies a block to be erased for each of the timings of erasure based on the acceleration number (step S3604). The design support apparatus 100 determines whether the blocks to be erased identified for the timings of the erasure include a block having one as a component of the column vector corresponding to the timing of the erasure and the block to be erased (step S3605). If it is determined that no block has one as a component (step S3605: NO), the design support apparatus 100 provides an output indicating that the encoding circuit can be utilized without change (step S3606) and terminates the series of operations.

On the other hand, if it is determined that any block has one as a component (step S3605: YES), the design support apparatus 100 acquires the template logical expression (step S3701). The design support apparatus 100 generates a logical expression for each of the column vectors (step S3702). The design support apparatus 100 generates the logical expression X for performing the logical AND operations of the generated logical expressions (step S3703). The design support apparatus 100 obtains the values of the variables of the logical expression X (step S3704). The design support apparatus 100 identifies a combination of values of variables setting the logical expression X to TRUE (step S3705).

The design support apparatus 100 identifies the timing corresponding to the column vector based on the identified combination (step S3706). The design support apparatus 100 generates circuit information representative of the encoding circuit and the control circuit based on the identified combination and the identified timing (step S3707) and terminates the series of operations.

By utilizing the characteristics of FPGA, the encoding process can be improved in process speed without adding a hardware resource. A BRAM embedded in an FPGA is limited in configurable pattern. For example, in the case of 7-series FPGAs of XILINX, a 36-[Kbit] BRAM is the minimum configuration unit. In the case of configuration of 72-bit width*512 words, encoding hardware can store four 1-[KB] blocks when utilized with 64 bits*512 words. Eight bytes*128=1024 Bytes and 4 [KB]=4096 Bytes are satisfied. By utilizing this BRAM in an input unit of the encoding hardware, four sets of data (=16 KB*4) can sequentially be input without adding a BRAM and the throughput can be improved.

As described above, for each timing during accelerated execution, the design support apparatus 100 identifies an operation based on data overwritten due to the accelerated execution and another timing having the same result of the operation as that of the timing from the encoding matrix. This enables the design of an encoding circuit capable of accelerated execution by less memory. This enables the design of an encoding circuit capable of accelerated execution with memory savings. Therefore, the throughput of the encoding process can be improved even with memory savings.

The design support apparatus 100 generates the circuit information representative of the encoding circuit and the control circuit based on the identified logical operation and the identified timing. As a result, the encoding circuit may be designed automatically and the burden of a designer may be reduced.

The design support apparatus 100 sorts the column vectors for generating reduction blocks among the column vectors of the encoding matrix in ascending order of the number of consecutive zeros from a first component. As a result, more accelerated execution is enabled with a smaller memory.

The design support method described in the present embodiment may be implemented by executing a prepared design support program on a computer such as a personal computer and a workstation. The design support program is stored on a computer-readable recording medium such as a magnetic disk, an optical disk, universal serial bus (USB) flash memory, read out from the computer-readable medium, and executed by the computer. The program may be distributed through a network such as the Internet.

EXPLANATIONS OF LETTERS OR NUMERALS

| | |
|---|---|
| 100 | design support apparatus |
| 101 | encoding circuit |
| 601, 602, 801, 802 | partial circuits |
| ma1, ma2 | encoding matrix |
| d1 | first object data |
| d2 | second object data |

**Claims**

1. A design support method of supporting design of an encoding circuit and obtaining a second number of encoded data by performing an encoding process for vectors of an encoding matrix having the second number of the vectors each having a predetermined number (hereinafter, "first number") of components, the second number being larger than the first number, the encoding process including a plurality of logical operations based on a plurality of partial data and the components of the vector, the plurality of partial data being obtained by dividing object data to be encoded into the first number and stored in the first number of storage areas, the method comprising:

   acquiring, by a computer, the encoding matrix;

acquiring, by the computer, information indicative of a start timing of starting storage of a plurality of second partial data into the storage areas among timings corresponding to the vectors in the encoding process based on a plurality of first partial data and the components of the vectors of the encoding matrix, the plurality of second partial data being obtained by dividing second object data to be encoded, the plurality of first partial data being obtained by dividing first object data to be encoded and being stored in the storage areas;

identifying, by computer and for each of the timings after the start timing indicated by the acquired information among the timings, first partial data overwritten by the second partial data at the timing among the plurality of first partial data stored in the storage areas;

identifying, by the computer and for each of the timings after the start timing, a logical operation based on the identified first partial data among the plurality of logical operations when among the components of the vector corresponding to the timing, a component corresponding to the identified first partial data is a predetermined value; and

identifying, by the computer and for each of timings after the start timing, a timing among timings before the start timing included in the timings and having a same operation result of the identified logical operation as the operation result of the identified logical operation based on the vector corresponding to the timing.

2. The design support method according to claim 1, wherein
the identifying the logical operation and the identifying the timing are performed such that when two different timings among the timings after the start timing have the same identified logical operations and differing operation results of the identified logical operations, the identified logical operations do not overlap between the two different timings.

3. The design support method according to claim 1 or 2, and further comprising
generating, by the computer, circuit information representative of a second encoding circuit that is the encoding circuit provided with a storage area for storing an operation result of the logical operation identified for each of the timings after the start timing, and a control circuit storing into the storage area, for each of the timings after the start timing, the operation result of the identified logical operation at the timing identified.

4. The design support method according to any one of claims 1 to 3, and further comprising:

counting, by the computer, a number of consecutive times that a value different from the predetermined value occurs from a first component for each of the vectors after the first number among the vectors of the acquired encoding matrix, and

generating, by the computer and based on the encoding matrix, an encoding matrix having the vectors after the first number sorted in ascending order of the counted number of the times that the value different from the predetermined value occurs, wherein

the identifying the logical operation includes, for each of the timings after the start timing, identifying a logical operation based on the identified first partial data among the plurality of logical operations when among the components of the vector of the generated encoding matrix corresponding to the timing, a component corresponding to the identified first partial data has the predetermined value.

5. A design support program of supporting design of an encoding circuit and obtaining a second number of encoded data by performing an encoding process for vectors of an encoding matrix having the second number of the vectors each having a predetermined number (hereinafter, "first number") of components, the second number being larger than the first number, the encoding process including a plurality of logical operations based on a plurality of partial data and the components of the vector, the plurality of partial data being obtained by dividing object data to be encoded into the first number and stored in the first number of storage areas, the program causing a computer to execute a process comprising:

acquiring the encoding matrix;
acquiring information indicative of a start timing of starting storage of a plurality of second partial data into the storage areas among timings corresponding to the vectors in the encoding process based on a plurality of first partial data and the components of the vectors of the encoding matrix, the plurality of second partial data being obtained by dividing second object data to be encoded, the plurality of first partial data being obtained by dividing first object data to be encoded and being stored in the storage areas;

identifying for each of the timings after the start timing indicated by the acquired information among the timings, first partial data overwritten by the second partial data at the timing among the plurality of first partial data stored in the storage areas;

identifying for each of the timings after the start timing, a logical operation based on the identified first partial data among the plurality of logical operations when among the components of the vector corresponding to the timing, a component corresponding to the identified first partial data is a predetermined value; and

identifying for each of timings after the start timing, a timing among timings before the start timing included in the timings and having a same operation result of the identified logical operation as the operation result of the identified logical operation based on the vector corresponding to the timing.

6. A design support apparatus configured to support design of an encoding circuit and obtain a second number of encoded data by performing an encoding process for vectors of an encoding matrix having the second number of the vectors each having a predetermined number (hereinafter, "first number") of components, the second number being larger than the first number, the encoding process including a plurality of logical operations based on a plurality of partial data and the components of the vector, the plurality of partial data being obtained by dividing object data to be encoded into the first number and stored in the first number of storage areas, the apparatus comprising:

a control circuit configured to acquire the encoding matrix; acquire information indicative of a start timing of starting storage of a plurality of second partial data into the storage areas among timings corresponding to the vectors in the encoding process based on a plurality of first partial data and the components of the vectors of the encoding matrix, the plurality of second partial data being obtained by dividing second object data to be encoded, the plurality of first partial data being obtained by dividing first object data to be encoded and being stored in the storage areas; identify for each of the timings after the start timing indicated by the acquired information among the timings, first partial data overwritten by the second partial data at the timing among the plurality of first partial data stored in the storage areas; identify for each of the timings after the start timing, a logical operation based on the identified first partial data among the plurality of logical operations when among the components of the vector corresponding to the timing, a component corresponding to the identified first partial data is a predetermined value; and identify for each of timings after the start timing, a timing among timings before the start timing included in the timings and having a same operation result of the identified logical operation as the operation result of the identified logical operation based on the vector corresponding to the timing.

7. A computer-readable recording medium storing therein a design support program of supporting design of an encoding circuit and obtaining a second number of encoded data by performing an encoding process for vectors of an encoding matrix having the second number of the vectors each having a predetermined number (hereinafter, "first number") of components, the second number being larger than the first number, the encoding process including a plurality of logical operations based on a plurality of partial data and the components of the vector, the plurality of partial data being obtained by dividing object data to be encoded into the first number and stored in the first number of storage areas, the program causing a computer to execute a process comprising:

acquiring the encoding matrix;

acquiring information indicative of a start timing of starting storage of a plurality of second partial data into the storage areas among timings corresponding to the vectors in the encoding process based on a plurality of first partial data and the components of the vectors of the encoding matrix, the plurality of second partial data being obtained by dividing second object data to be encoded, the plurality of first partial data being obtained by dividing first object data to be encoded and being stored in the storage areas;

identifying for each of the timings after the start timing indicated by the acquired information among the timings, first partial data overwritten by the second partial data at the timing among the plurality of first partial data stored in the storage areas;

identifying for each of the timings after the start timing, a logical operation based on the identified first partial data among the plurality of logical operations when among the components of the vector corresponding to the timing, a component corresponding to the identified first partial data is a predetermined value; and

identifying for each of timings after the start timing, a timing among timings before the start timing included in the timings and having a same operation result of the identified logical operation as the operation result of the identified logical operation based on the vector corresponding to the timing.

# FIG.1

<OBJECT DATA>    <INPUT BLOCK>    <ENCODED BLOCK>    FIG.2

| 16-[KB] DATA |

⇨

| BLOCK[0] |
| BLOCK[1] |
| BLOCK[2] |

⋮

| BLOCK[15] |

⇨

| BLOCK[0] |
| BLOCK[1] |
| BLOCK[2] |

⋮

| BLOCK[15] |

⇨

INTERNET

(BLOCK[0])XOR(BLOCK[1])XOR⋯(BLOCK[15])= | REDUNDANT BLOCK[0] |

(BLOCK[0])XOR(BLOCK[1])XOR(BLOCK[4])⋯= | REDUNDANT BLOCK[1] |

(BLOCK[2])XOR(BLOCK[3])XOR(BLOCK[6])⋯= | REDUNDANT BLOCK[2] |

FIG.3

<ENCODED BLOCK>   <RESTORED BLOCK>   <OBJECT DATA>

INTERNET

| BLOCK[0] |
| BLOCK[1] |
| BLOCK[2] |

PACKET DROP

⋮

| BLOCK[15] |
| REDUNDANT BLOCK[0] |
| REDUNDANT BLOCK[1] |
| REDUNDANT BLOCK[2] |

| BLOCK[0] |
| BLOCK[1] |
| BLOCK[2] |

⋮

| BLOCK[15] |

| 16-[KB] DATA |

$(BLOCK[0])XOR(BLOCK[1])XOR(BLOCK[3])XOR\cdots(BLOCK[15])XOR(REDUNDANT\ BLOCK[0])=BLOCK[2]$

# FIG.4

CPU  ~401

PRIMARY STORAGE DEVICE (RAM)  ~402

RPS SOFTWARE UNIT  421

PCI EXPRESS BUS  403

400

EXPANSION BOARD

RAM  411

FPGA  412

LAN CONNECTOR  413

RPS HARDWARE UNIT  422

404

NET

LAN/WAN

430

FIG.5

FIG.6

# FIG.7

601

0 or 1

701    703    705    706

64    64    64    64    64

BRAM    REG    REG

BRAM    REG

702    704

64    64    64

64    64

REG

710    711    602

64

WDATA    64    64    RDATA

WADDR    9    BRAM    9    RADDR

WEN

FIG.8

FIG.9

# FIG.10

# FIG.11

1102

1101

STORAGE UNIT

CONTROL UNIT

TEMPLATE
LOGICAL
EXPRESSION

CIRCUIT
INFORMATION

## FIG.12

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 |
|---|---|---|---|---|---|---|---|---|---|---|----|----|----|----|----|----|----|----|----|----|----|----|----|----|----|----|----|----|----|----|
| BRAM0 | 1 | 0 | 0 | 0 | 0 | 0 | 0 | 0 | 0 | 0 | 0 | 0 | 0 | 0 | 0 | 0 | 0 | 1 | 1 | 1 | 1 | 1 | 0 | 0 | 0 | 1 | 0 | 1 | 0 | 1 |
| BRAM1 | 0 | 1 | 0 | 0 | 0 | 0 | 0 | 0 | 0 | 0 | 0 | 0 | 0 | 0 | 0 | 0 | 0 | 1 | 0 | 1 | 1 | 1 | 1 | 0 | 1 | 0 | 0 | 1 | 0 | 0 |
| BRAM2 | 0 | 0 | 1 | 0 | 0 | 0 | 0 | 0 | 0 | 0 | 0 | 0 | 0 | 0 | 0 | 0 | 0 | 1 | 1 | 0 | 1 | 1 | 1 | 1 | 0 | 1 | 1 | 1 | 0 | 0 |
| BRAM3 | 0 | 0 | 0 | 1 | 0 | 0 | 0 | 0 | 0 | 0 | 0 | 0 | 0 | 0 | 0 | 0 | 0 | 1 | 0 | 0 | 1 | 1 | 0 | 1 | 0 | 0 | 1 | 1 | 1 | 1 |
| BRAM4 | 0 | 0 | 0 | 0 | 1 | 0 | 0 | 0 | 0 | 0 | 0 | 0 | 0 | 0 | 0 | 0 | 0 | 1 | 1 | 1 | 0 | 1 | 0 | 0 | 1 | 1 | 0 | 1 | 0 | 1 |
| BRAM5 | 0 | 0 | 0 | 0 | 0 | 1 | 0 | 0 | 0 | 0 | 0 | 0 | 0 | 0 | 0 | 0 | 0 | 1 | 0 | 1 | 0 | 1 | 1 | 0 | 1 | 1 | 1 | 0 | 1 | 0 |
| BRAM6 | 0 | 0 | 0 | 0 | 0 | 0 | 1 | 0 | 0 | 0 | 0 | 0 | 0 | 0 | 0 | 0 | 0 | 1 | 1 | 0 | 0 | 1 | 1 | 1 | 0 | 0 | 0 | 1 | 1 | 1 |
| BRAM7 | 0 | 0 | 0 | 0 | 0 | 0 | 0 | 1 | 0 | 0 | 0 | 0 | 0 | 0 | 0 | 0 | 0 | 1 | 0 | 0 | 0 | 1 | 0 | 1 | 0 | 1 | 1 | 1 | 1 | 0 |
| BRAM8 | 0 | 0 | 0 | 0 | 0 | 0 | 0 | 0 | 1 | 0 | 0 | 0 | 0 | 0 | 0 | 0 | 0 | 1 | 1 | 1 | 1 | 0 | 0 | 0 | 1 | 0 | 1 | 1 | 0 | 1 |
| BRAM9 | 0 | 0 | 0 | 0 | 0 | 0 | 0 | 0 | 0 | 1 | 0 | 0 | 0 | 0 | 0 | 0 | 0 | 1 | 0 | 1 | 1 | 0 | 1 | 0 | 1 | 0 | 1 | 0 | 1 | 0 |
| BRAM10 | 0 | 0 | 0 | 0 | 0 | 0 | 0 | 0 | 0 | 0 | 1 | 0 | 0 | 0 | 0 | 0 | 0 | 1 | 1 | 0 | 1 | 0 | 1 | 1 | 1 | 1 | 0 | 0 | 1 | 0 |
| BRAM11 | 0 | 0 | 0 | 0 | 0 | 0 | 0 | 0 | 0 | 0 | 0 | 1 | 0 | 0 | 0 | 0 | 0 | 1 | 0 | 0 | 1 | 0 | 0 | 1 | 0 | 1 | 1 | 1 | 0 | 1 |
| BRAM12 | 0 | 0 | 0 | 0 | 0 | 0 | 0 | 0 | 0 | 0 | 0 | 0 | 1 | 0 | 0 | 0 | 0 | 1 | 1 | 1 | 0 | 0 | 1 | 0 | 0 | 0 | 0 | 1 | 1 | 0 |
| BRAM13 | 0 | 0 | 0 | 0 | 0 | 0 | 0 | 0 | 0 | 0 | 0 | 0 | 0 | 1 | 0 | 0 | 0 | 1 | 0 | 1 | 0 | 0 | 1 | 0 | 1 | 1 | 1 | 0 | 0 | 1 |
| BRAM14 | 0 | 0 | 0 | 0 | 0 | 0 | 0 | 0 | 0 | 0 | 0 | 0 | 0 | 0 | 1 | 0 | 0 | 1 | 1 | 0 | 0 | 0 | 0 | 1 | 1 | 0 | 0 | 1 | 1 | 1 |
| BRAM15 | 0 | 0 | 0 | 0 | 0 | 0 | 0 | 0 | 0 | 0 | 0 | 0 | 0 | 0 | 0 | 1 | 1 | 1 | 0 | 0 | 0 | 0 | 1 | 1 | 1 | 1 | 1 | 0 | 1 | 1 |

ma1

# FIG.13

TIME →

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 |
|---|---|---|---|---|---|---|---|---|---|---|---|---|---|---|---|---|---|---|---|---|---|---|---|---|---|---|---|---|---|---|
| BRAM0 | # | | | | | | | | | | | | | | | | # | # | # | # | # | | | | # | | # | | # | |
| BRAM1 | | # | | | | | | | | | | | | | | | # | | # | # | # | # | | # | | | # | | | |
| BRAM2 | | | # | | | | | | | | | | | | | | # | # | | # | # | # | # | | # | # | # | | | |
| BRAM3 | | | | # | | | | | | | | | | | | | # | | | # | # | | # | | | # | # | # | | # |
| BRAM4 | | | | | # | | | | | | | | | | | | # | # | # | | # | | | # | # | | # | | | # |
| BRAM5 | | | | | | # | | | | | | | | | | | # | | # | | # | # | | # | # | # | | # | | |
| BRAM6 | | | | | | | # | | | | | | | | | | # | # | | | # | # | # | | | | # | # | | # |
| BRAM7 | | | | | | | | # | | | | | | | | | # | | | | # | | # | | # | # | # | # | # | |
| BRAM8 | | | | | | | | | # | | | | | | | | # | # | # | # | | | | # | | # | # | | | # |
| BRAM9 | | | | | | | | | | # | | | | | | | # | | # | # | | # | | # | | # | | | # | # |
| BRAM10 | | | | | | | | | | | # | | | | | | # | # | | # | | # | # | # | # | | | # | # | |
| BRAM11 | | | | | | | | | | | | # | | | | | # | | | # | | | # | | # | # | # | | | # |
| BRAM12 | | | | | | | | | | | | | # | | | | # | # | # | | | # | | | | | # | # | # | |
| BRAM13 | | | | | | | | | | | | | | # | | | # | | # | | | # | | # | # | # | | | # | # |
| BRAM14 | | | | | | | | | | | | | | | # | | # | # | | | | | # | # | | | # | # | # | # |
| BRAM15 | | | | | | | | | | | | | | | | # | # | | | | | # | # | # | # | # | | | # | # |

# FIG.14

## FIG.15

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 |
|---|---|---|---|---|---|---|---|---|---|---|---|---|---|---|---|---|---|---|---|---|---|---|---|---|---|---|---|---|---|---|
| BRAM0 | # | | | | | | | | | | | | | | | | # | # | # | # | # | | | | | | # | | # | |
| BRAM1 | | # | | | | | | | | | | | | | | | # | | # | # | # | # | | | # | | | # | | |
| BRAM2 | | | # | | | | | | | | | | | | | | # | # | | # | # | # | | | # | # | # | | | |
| BRAM3 | | | | # | | | | | | | | | | | | | # | | | # | # | # | | | # | # | | # | | # |
| BRAM4 | | | | | # | | | | | | | | | | | | # | # | # | | # | | | # | # | | # | | | # |
| BRAM5 | | | | | | # | | | | | | | | | | | # | | # | | | | # | # | # | | | | | |
| BRAM6 | | | | | | | # | | | | | | | | | | # | # | | | | # | | | | | # | # | # | # |
| BRAM7 | | | | | | | | # | | | | | | | | | # | | | | # | | # | | # | # | # | # | # | |
| BRAM8 | | | | | | | | | # | | | | | | | | # | # | # | # | | | | # | | | # | # | # | |
| BRAM9 | | | | | | | | | | # | | | | | | | # | | # | # | | # | | | # | | | | # | # |
| BRAM10 | | | | | | | | | | | # | | | | | | # | # | | # | | # | # | # | | | | # | # | |
| BRAM11 | | | | | | | | | | | | # | | | | | # | | | # | | | # | | # | | | | | # |
| BRAM12 | | | | | | | | | | | | | # | | | | # | # | # | | | # | | | | | # | # | # | |
| BRAM13 | | | | | | | | | | | | | | # | | | # | | # | | | # | | # | # | # | | | # | # |
| BRAM14 | | | | | | | | | | | | | | | # | | # | # | | | | # | # | | | | # | # | # | # |
| BRAM15 | | | | | | | | | | | | | | | | # | # | | | | | # | # | # | # | # | | | # | # |

## FIG.16

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | | | eat | buffer |
|---|---|---|---|---|---|---|---|---|---|---|---|---|---|---|---|---|---|---|---|---|---|---|---|---|---|---|---|---|---|---|---|---|---|---|
| BRAM0 | # | | | | | | | | | | | | | | | | # | # | # | # | # | | | | # | | # | | # | /// | | | 1 | 0 |
| BRAM1 | | # | | | | | | | | | | | | | | | # | | # | # | # | # | | # | | | # | | | | | | | |
| BRAM2 | | | # | | | | | | | | | | | | | | # | # | | # | # | # | # | | # | # | # | | | | | | | |
| BRAM3 | | | | # | | | | | | | | | | | | | # | | | # | # | | # | | | # | # | # | | # | | | | |
| BRAM4 | | | | | # | | | | | | | | | | | | # | # | # | | # | | | # | # | | # | | | # | | | | |
| BRAM5 | | | | | | # | | | | | | | | | | | # | | # | | # | # | | # | # | # | | # | | | | | | |
| BRAM6 | | | | | | | # | | | | | | | | | | # | # | | # | # | # | | | | # | # | | # | | | | | |
| BRAM7 | | | | | | | | # | | | | | | | | | # | | | # | | # | | # | # | # | # | # | | | | | | |
| BRAM8 | | | | | | | | | # | | | | | | | | # | # | # | # | | | | # | | # | # | | # | | | | | |
| BRAM9 | | | | | | | | | | # | | | | | | | # | | # | # | | # | | # | | # | | # | # | | | | | |
| BRAM10 | | | | | | | | | | | # | | | | | | # | # | | # | | # | # | # | # | | | # | # | | | | | |
| BRAM11 | | | | | | | | | | | | # | | | | | # | | | # | | # | | # | # | # | | | # | | | | | |
| BRAM12 | | | | | | | | | | | | | # | | | | # | # | # | | | # | | | | | # | # | # | | | | | |
| BRAM13 | | | | | | | | | | | | | | # | | | # | | # | | | # | | # | # | # | | | # | # | | | | |
| BRAM14 | | | | | | | | | | | | | | | # | | # | # | | | | | # | # | | # | # | # | # | | | | | |
| BRAM15 | | | | | | | | | | | | | | | | # | # | | | | | # | # | # | # | # | | | # | # | | | | |

## FIG.17

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | | eat | buffer |
|---|---|---|---|---|---|---|---|---|---|---|----|----|----|----|----|----|----|----|----|----|----|----|----|----|----|----|----|----|----|----|---|-----|--------|
| BRAM0 | ▓ | | | | | | | | | | | | | | | | # | # | # | # | # | | | | # | | # | | # | ◫ | | 1 | 0 |
| BRAM1 | | # | | | | | | | | | | | | | | | # | | # | # | # | # | | # | | | # | | | | | 2 | 1 |
| BRAM2 | | | # | | | | | | | | | | | | | | # | # | | # | # | # | # | | # | # | # | | | | | | |
| BRAM3 | | | | # | | | | | | | | | | | | | # | | | # | # | | # | | # | # | # | | # | | | | |
| BRAM4 | | | | | # | | | | | | | | | | | | # | # | # | | # | | # | # | | # | | | # | | | | |
| BRAM5 | | | | | | # | | | | | | | | | | | # | | # | | # | # | | # | # | # | | # | | | | | |
| BRAM6 | | | | | | | # | | | | | | | | | | # | # | | # | # | # | | | | # | # | | # | | | | |
| BRAM7 | | | | | | | | # | | | | | | | | | # | | | | # | | # | | # | # | # | # | # | | | | |
| BRAM8 | | | | | | | | | # | | | | | | | | # | # | # | # | | | | # | | # | # | | # | | | | |
| BRAM9 | | | | | | | | | | # | | | | | | | # | | # | # | | # | | # | | # | | # | # | | | | |
| BRAM10 | | | | | | | | | | | # | | | | | | # | # | | # | | # | # | # | # | | # | # | | | | | |
| BRAM11 | | | | | | | | | | | | # | | | | | # | | | # | | | # | | # | # | # | | # | | | | |
| BRAM12 | | | | | | | | | | | | | # | | | | # | # | # | | | # | | | | # | # | # | | | | | |
| BRAM13 | | | | | | | | | | | | | | # | | | # | | # | | | # | | # | # | # | | # | # | | | | |
| BRAM14 | | | | | | | | | | | | | | | # | | # | # | | | | | # | # | | # | # | # | # | | | | |
| BRAM15 | | | | | | | | | | | | | | | | # | # | | | | # | # | # | # | # | | | # | # | | | | |

## FIG.18

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | | eat | buffer |
|---|---|---|---|---|---|---|---|---|---|---|---|---|---|---|---|---|---|---|---|---|---|---|---|---|---|---|---|---|---|---|---|---|---|
| BRAM0 | # | | | | | | | | | | | | | | | | # | # | # | # | # | | | | # | | # | | # | | | 1 | 0 |
| BRAM1 | | # | | | | | | | | | | | | | | | # | | # | # | # | # | | # | | | # | | # | | | 2 | 1 |
| BRAM2 | | | # | | | | | | | | | | | | | | # | # | | # | # | # | # | | # | # | # | | | | | 3 | 1 |
| BRAM3 | | | | # | | | | | | | | | | | | | # | | | # | # | | # | | | # | # | # | | # | | | |
| BRAM4 | | | | | # | | | | | | | | | | | | # | # | # | | # | | | # | # | | # | | | # | | | |
| BRAM5 | | | | | | # | | | | | | | | | | | # | | # | | # | # | | # | # | # | | # | | | | | |
| BRAM6 | | | | | | | # | | | | | | | | | | # | # | | | # | # | # | | | | # | # | | # | | | |
| BRAM7 | | | | | | | | # | | | | | | | | | # | | | | # | | # | | # | # | # | # | # | | | | |
| BRAM8 | | | | | | | | | # | | | | | | | | # | # | # | # | | | | # | | # | # | | | # | | | |
| BRAM9 | | | | | | | | | | # | | | | | | | # | | # | # | | # | | # | | # | | # | # | | | | |
| BRAM10 | | | | | | | | | | | # | | | | | | # | # | | # | | # | # | # | # | | | # | # | | | | |
| BRAM11 | | | | | | | | | | | | # | | | | | # | | | # | | | # | | # | # | # | | # | | | | |
| BRAM12 | | | | | | | | | | | | | # | | | | # | # | # | | | # | | | | | # | # | # | | | | |
| BRAM13 | | | | | | | | | | | | | | # | | | # | | # | | | # | | # | # | # | | | # | # | | | |
| BRAM14 | | | | | | | | | | | | | | | # | | # | # | | | | | # | # | | | # | # | # | # | | | |
| BRAM15 | | | | | | | | | | | | | | | | # | # | | | | | # | # | # | # | # | | | # | # | | | |

EP 3 119 005 A1

## FIG.19

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | | eat | buffer |
|---|---|---|---|---|---|---|---|---|---|---|---|---|---|---|---|---|---|---|---|---|---|---|---|---|---|---|---|---|---|---|---|---|---|
| BRAM0 | # | | | | | | | | | | | | | | | | # | # | # | # | # | | | | # | | # | # | # | # | | 1 | 0 |
| BRAM1 | | # | | | | | | | | | | | | | | | # | | # | # | # | # | | # | | | # | # | # | # | | 2 | 1 |
| BRAM2 | | | # | # | | | | | | | | | | | | | # | # | | # | # | # | # | | # | # | # | # | | # | | 3 | 1 |
| BRAM3 | | | | # | | | | | | | | | | | | | # | | # | # | | # | | | # | | # | # | | # | | 4 | 3 |
| BRAM4 | | | | | # | | | | | | | | | | | | # | # | # | | # | | | # | # | | # | | | # | | | |
| BRAM5 | | | | | | # | | | | | | | | | | | # | | # | | # | # | | # | # | # | | # | | | | | |
| BRAM6 | | | | | | | # | | | | | | | | | | # | # | | | # | # | # | | | | # | # | | # | | | |
| BRAM7 | | | | | | | | # | | | | | | | | | # | | | | # | | # | | # | # | # | # | # | | | | |
| BRAM8 | | | | | | | | | # | | | | | | | | # | # | # | # | | | | # | | # | # | | | # | | | |
| BRAM9 | | | | | | | | | | # | | | | | | | # | | # | # | | # | | # | | # | | # | # | | | | |
| BRAM10 | | | | | | | | | | | # | | | | | | # | # | | # | | # | # | # | # | | | # | # | | | | |
| BRAM11 | | | | | | | | | | | | # | | | | | # | | | # | | # | | # | # | # | | | # | | | | |
| BRAM12 | | | | | | | | | | | | | # | | | | # | # | # | | | # | | | | # | # | # | | | | | |
| BRAM13 | | | | | | | | | | | | | | # | | | # | | # | | | # | | # | # | # | | | # | # | | | |
| BRAM14 | | | | | | | | | | | | | | | # | | # | # | | | | | # | # | | # | # | # | # | | | | |
| BRAM15 | | | | | | | | | | | | | | | | # | # | | | | | # | # | # | # | # | | | # | # | | | |

39

# FIG.20

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | | | eat | buffer |
|---|---|---|---|---|---|---|---|---|---|---|---|---|---|---|---|---|---|---|---|---|---|---|---|---|---|---|---|---|---|---|---|---|---|---|
| BRAM0 | # | | | | | | | | | | | | | | | | # | # | # | # | # | | | | # | | # | | # | | | | 1 | 0 |
| BRAM1 | | # | | | | | | | | | | | | | | | # | | # | # | # | # | | # | | | # | | | | | | 2 | 1 |
| BRAM2 | | | # | # | | | | | | | | | | | | | # | # | | # | # | # | # | | # | # | # | | | | | | 3 | 1 |
| BRAM3 | | | | # | | | | | | | | | | | | | # | | | # | # | | # | | | # | # | # | | # | | | 4 | 3 |
| BRAM4 | | | | | # | | | | | | | | | | | | # | # | # | | # | | | # | # | | # | | | # | | | 5 | 4 |
| BRAM5 | | | | | # | # | | | | | | | | | | | # | | # | | # | # | | # | # | # | | # | | | | | | |
| BRAM6 | | | | | | | # | | | | | | | | | | # | # | | # | # | # | | | | # | # | | # | | | | | |
| BRAM7 | | | | | | | | # | | | | | | | | | # | | | # | | # | | # | # | # | # | # | | | | | | |
| BRAM8 | | | | | | | | | # | | | | | | | | # | # | # | # | | | # | | | # | # | | # | | | | | |
| BRAM9 | | | | | | | | | | # | | | | | | | # | | # | # | | # | | # | | # | | # | # | | | | | |
| BRAM10 | | | | | | | | | | | # | | | | | | # | # | | # | | # | # | # | # | | | # | # | | | | | |
| BRAM11 | | | | | | | | | | | | # | | | | | # | | | # | | | # | | # | # | # | | # | | | | | |
| BRAM12 | | | | | | | | | | | | | # | | | | # | # | # | | | # | | | | | # | # | # | | | | | |
| BRAM13 | | | | | | | | | | | | | | # | | | # | | # | | | # | | # | # | # | | | # | # | | | | |
| BRAM14 | | | | | | | | | | | | | | | # | | # | # | | | | | # | # | | | # | # | # | # | | | | |
| BRAM15 | | | | | | | | | | | | | | | | # | # | | | | | # | # | # | # | # | | | # | # | | | | |

# FIG.21

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | | eat | buffer |
|---|---|---|---|---|---|---|---|---|---|---|---|---|---|---|---|---|---|---|---|---|---|---|---|---|---|---|---|---|---|---|---|---|---|
| BRAM0 | # | | | | | | | | | | | | | | | | # | # | # | # | # | | | | # | | # | | # | | | 1 | 0 |
| BRAM1 | | # | | | | | | | | | | | | | | | # | | # | # | # | # | | # | | | # | | | | | 2 | 1 |
| BRAM2 | | | # | # | | | | | | | | | | | | | # | # | | # | # | # | # | | # | # | # | | | | | 3 | 1 |
| BRAM3 | | | | # | | | | | | | | | | | | | # | | | # | # | | # | | | # | # | | # | | | 4 | 3 |
| BRAM4 | | | | | # | | | | | | | | | | | | | # | # | # | | # | | | # | # | | # | | # | | 5 | 4 |
| BRAM5 | | | | | # | # | | | | | | | | | | | | # | | # | | # | # | | # | # | # | | # | | | 6 | 4 |
| BRAM6 | | | | | | | # | | | | | | | | | | | # | # | | | # | # | # | | | # | # | | # | | | |
| BRAM7 | | | | | | | | # | | | | | | | | | | # | | | # | | # | | # | # | # | # | # | | | | |
| BRAM8 | | | | | | | | | # | | | | | | | | | # | # | # | # | | | # | | # | # | | | # | | | |
| BRAM9 | | | | | | | | | | # | | | | | | | | # | | # | # | | # | | # | | # | | # | # | | | |
| BRAM10 | | | | | | | | | | | # | | | | | | | # | # | | # | | # | # | # | # | | | # | # | | | |
| BRAM11 | | | | | | | | | | | | # | | | | | | # | | | # | | | # | | # | # | # | | # | | | |
| BRAM12 | | | | | | | | | | | | | # | | | | | # | # | # | | | # | | | | # | # | # | | | | |
| BRAM13 | | | | | | | | | | | | | | # | | | | # | | # | | | # | | # | | # | # | | # | # | | |
| BRAM14 | | | | | | | | | | | | | | | # | | | # | # | | | | # | # | | | # | # | # | # | | | |
| BRAM15 | | | | | | | | | | | | | | | | # | # | | | | | # | # | # | # | # | | | # | # | | | |

## FIG.22

| | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | | eat | buffer |
|---|---|---|---|---|---|---|---|---|---|---|---|---|---|---|---|---|---|---|---|---|---|---|---|---|---|---|---|---|---|---|---|---|---|
| BRAM0 | # | # | | | | | | | | | | | | | | | # | # | # | # | # | | | # | # | | # | # | # | # | | 1 | 0 |
| BRAM1 | # | # | | | | | | | | | | | | | | | # | | # | # | # | # | | # | # | | # | # | # | | | 2 | 1 |
| BRAM2 | | | # | # | | | | | | | | | | | | | # | # | | # | # | # | # | | # | # | # | # | # | | | 3 | 1 |
| BRAM3 | | | | # | | | | | | | | | | | | | # | | | # | # | | # | | # | # | # | # | | # | | 4 | 3 |
| BRAM4 | | | | | # | | | | | | | | | | | | # | # | # | | # | | | # | # | | # | # | | # | | 5 | 4 |
| BRAM5 | | | | | | # | # | | | | | | | | | | # | | # | | # | # | | # | # | # | | # | # | | | 6 | 4 |
| BRAM6 | | | | | | | # | | | | | | | | | | # | # | | # | # | # | | | # | # | | | # | | | 7 | NA |
| BRAM7 | | | | | | | # | # | | | | | | | | | # | | | # | | # | | # | # | # | # | # | | | | | |
| BRAM8 | | | | | | | | | # | | | | | | | | # | # | # | # | | | # | | # | # | | | # | | | | |
| BRAM9 | | | | | | | | | | # | | | | | | | # | | # | # | | # | | # | | # | | # | # | | | | |
| BRAM10 | | | | | | | | | | | # | | | | | | # | # | | # | | # | # | # | # | | | # | # | | | | |
| BRAM11 | | | | | | | | | | | | # | | | | | # | | | # | | | # | | # | # | # | | # | | | | |
| BRAM12 | | | | | | | | | | | | | # | | | | # | # | # | | | # | | | # | # | # | | | | | | |
| BRAM13 | | | | | | | | | | | | | | # | | | # | | # | | | # | | # | # | # | | # | # | | | | |
| BRAM14 | | | | | | | | | | | | | | | # | | # | # | | | | # | # | | # | # | # | # | | | | | |
| BRAM15 | | | | | | | | | | | | | | | | # | # | | | | | # | # | # | # | # | | # | # | | | | |

FIG.23

FIG.24

# FIG.25

\<EXAMPLE OF POSSIBLE/IMPOSSIBLE STORAGE\>

# FIG.26

2600

TEMPLATE
LOGICAL
EXPRESSION

$((c0=*) \mid (((b0=*) \mid (a0=*)\&(a1=*)) \& ((b1=*) \mid (a2=*)\&(a3=*))))$
$\&$
$((c1=*) \mid (((b2=*) \mid (a4=*)\&(a5=*)) \& ((b3=*) \mid (a6=*)\&(a7=*))))$

# FIG.27

<ACCESS TIMING DIAGRAM>

<CORRESPONDENCE RELATION BETWEEN VARIABLES AND BRAM POSITIONS>

# FIG.28

2800

```
#include <stdio.h>

int
main( int argc, char* argv[] )
{
        int a0,a1,a2;
        int b0,b1;
        int c0;
        int X;
        int n;

        for ( c0=0; c0 <= 255; c0 ++ )
            for ( b0=0; b0 <= 15; b0 ++ )
                for ( b1=0; b1 <= 15; b1 ++ )
                    for ( a0=0; a0 <= 3; a0 ++ )
                        for ( a1=0; a1 <= 3; a1 ++ )
                            for ( a2=0; a2 <= 3; a2 ++ ) {
                                X= ((c0==88) |
((((b0==8) | (a1==2)) & ((b1==5) | (a2==1))))) &
                                    ((c0==129) |
(b0==1) | (a0==1)) &
                                    ((c0==232) |
(b0==8) | (a1==2)) &
                                    ((c0==223) |
(b0==15) | (a0==3)&(a1==3)) &
                                    ((c0==181) |
(b0==5) | (a0==1));
                                if ( X != 0 ) {
                                    n=0;
                                    if ( a0!=0) n++;
                                    if ( a1!=0) n++;
                                    if ( a2!=0) n++;
                                    if ( b0!=0) n++;
                                    if ( b1!=0) n++;
                                    if ( c0!=0) n++;
                                    printf("n=%d
a0=%d a1=%d a2=%d  b0=%d b1=%d  c0=%d¥n",
                                        n,
a0,a1,a2,  b0,b1, c0);
                                }
                            }

        return 0;
}
```

FIG.29                    2900

```
write_enable_a0 <= ( block_counter == 0 ) ? 1 : 0;
write_enable_a1 <= ( block_counter == 3 ) ? 1 : 0;
write_enable_a2 <= ( block_counter == 4 ) ? 1 : 0;
write_enable_b0 <= ( block_counter == 16 ) ? 1 : 0;
sel_a0 <= ( block_counter == 24 || block_counter == 28 ) ? 1 : 0;
sel_a1 <= ( block_counter == 27 || block_counter == 29 ) ? 1 : 0;
sel_a2 <= ( block_counter == 29 ) ? 1 : 0;
sel_b0 <= ( block_counter == 26 ) ? 1 : 0;
```

# FIG.30

TIME (CLOCK CYCLE) →

# FIG.31

BLOCK NUMBER COUNTER | 0 | 1 | --- | 3 | 4 | --- | 24 | 25

ADDRESS1 | 0 | 1 | 2 | ... | 1023 | 0 | 1 | 2 | ... | 1023 | --- | 0 | 1 | 2 | 3 | ... | 1023 | 0 | --- | 0 | 1 | 2 | ... | 1023 | 0

INPUT DATA/BRAM OUTPUT | d0 | d1 | d2 | ... | d1023 | d0 | d1 | d2 | ... | --- | d0 | d1 | d2 | d3 | ... | d1023 | d0 | --- | d0 | d1 | d2 | ... | d1023 | d0

XOR OPERATION RESULT | - | - | x0 | x1 | ... | x1022 | y0 | y1 | ... | --- | ... | ... | z0 | z1 | z2 | ... | ... | --- | ... | ... | p0 | p1 | ... | ...

ADDRESS2 | - | - | 0 | 1 | ... | 1022 | 1023 | 0 | 1 | ... | --- | 1022 | 1023 | 0 | 1 | 2 | ... | ... | --- | 1022 | 1023 | 0 | 1 | ... | ...

WRITE ENABLE 2_a0 | - | - | 1 | 0 | --- | 0 | --- | 0

WRITE ENABLE 2_a1 | - | - | 0 | 0 | --- | 1 | --- | 0

WRITE ENABLE 2_a2 | - | - | 0 | 0 | --- | 0 | --- | 0

WRITE ENABLE 2_b0 | - | - | 0 | 0 | --- | 0 | --- | 0

READ SELECTION_a0 | - | - | - | 0 | 0 | --- | 0 | --- | 1

SELOUTPUT DATA_a0 | - | - | - | x0 | x1 | x2 | ... | x1023 y0 | y1 | --- | z0 | z1 | ... | ... | --- | a0_0 | a0_1 | ... | ...

EP 3 119 005 A1

FIG.32

52

# FIG.33

FIG.34

**ma1**

| COLUMN NUMBER | 0 | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 |
|---|---|---|---|---|---|---|---|---|---|---|---|---|---|---|---|---|---|---|---|---|---|---|---|---|---|---|---|---|---|---|
| BRAM0 | 1 | 0 | 0 | 0 | 0 | 0 | 0 | 0 | 0 | 0 | 0 | 0 | 0 | 0 | 0 | 0 | 1 | 1 | 1 | 1 | 1 | 0 | 0 | 0 | 1 | 0 | 1 | 0 | 1 | 0 |
| BRAM1 | 0 | 1 | 0 | 0 | 0 | 0 | 0 | 0 | 0 | 0 | 0 | 0 | 0 | 0 | 0 | 0 | 1 | 0 | 1 | 1 | 1 | 1 | 0 | 1 | 0 | 0 | 1 | 0 | 0 | 0 |
| BRAM2 | 0 | 0 | 1 | 0 | 0 | 0 | 0 | 0 | 0 | 0 | 0 | 0 | 0 | 0 | 0 | 0 | 1 | 1 | 0 | 1 | 1 | 1 | 1 | 0 | 1 | 1 | 1 | 0 | 0 | 0 |
| BRAM3 | 0 | 0 | 0 | 1 | 0 | 0 | 0 | 0 | 0 | 0 | 0 | 0 | 0 | 0 | 0 | 0 | 1 | 0 | 0 | 1 | 1 | 0 | 1 | 0 | 0 | 1 | 1 | 1 | 0 | 1 |
| BRAM4 | 0 | 0 | 0 | 0 | 1 | 0 | 0 | 0 | 0 | 0 | 0 | 0 | 0 | 0 | 0 | 0 | 1 | 1 | 1 | 0 | 1 | 0 | 0 | 1 | 1 | 0 | 1 | 0 | 0 | 1 |
| BRAM5 | 0 | 0 | 0 | 0 | 0 | 1 | 0 | 0 | 0 | 0 | 0 | 0 | 0 | 0 | 0 | 0 | 1 | 0 | 1 | 0 | 1 | 1 | 0 | 1 | 1 | 1 | 0 | 1 | 0 | 0 |
| BRAM6 | 0 | 0 | 0 | 0 | 0 | 0 | 1 | 0 | 0 | 0 | 0 | 0 | 0 | 0 | 0 | 0 | 1 | 1 | 0 | 0 | 1 | 1 | 1 | 0 | 0 | 0 | 1 | 1 | 0 | 1 |
| BRAM7 | 0 | 0 | 0 | 0 | 0 | 0 | 0 | 1 | 0 | 0 | 0 | 0 | 0 | 0 | 0 | 0 | 1 | 0 | 0 | 1 | 0 | 1 | 0 | 1 | 1 | 1 | 1 | 1 | 1 | 0 |
| BRAM8 | 0 | 0 | 0 | 0 | 0 | 0 | 0 | 0 | 1 | 0 | 0 | 0 | 0 | 0 | 0 | 0 | 1 | 1 | 1 | 1 | 0 | 0 | 0 | 1 | 0 | 1 | 1 | 0 | 0 | 1 |
| BRAM9 | 0 | 0 | 0 | 0 | 0 | 0 | 0 | 0 | 0 | 1 | 0 | 0 | 0 | 0 | 0 | 0 | 1 | 1 | 0 | 1 | 1 | 0 | 1 | 0 | 1 | 0 | 1 | 1 | 1 | 0 |
| BRAM10 | 0 | 0 | 0 | 0 | 0 | 0 | 0 | 0 | 0 | 0 | 1 | 0 | 0 | 0 | 0 | 0 | 1 | 1 | 0 | 1 | 0 | 1 | 1 | 1 | 1 | 0 | 0 | 1 | 1 | 0 |
| BRAM11 | 0 | 0 | 0 | 0 | 0 | 0 | 0 | 0 | 0 | 0 | 0 | 1 | 0 | 0 | 0 | 0 | 1 | 0 | 0 | 1 | 0 | 0 | 1 | 0 | 1 | 1 | 1 | 0 | 0 | 1 |
| BRAM12 | 0 | 0 | 0 | 0 | 0 | 0 | 0 | 0 | 0 | 0 | 0 | 0 | 1 | 0 | 0 | 0 | 1 | 1 | 0 | 0 | 1 | 0 | 1 | 0 | 0 | 0 | 0 | 1 | 1 | 0 |
| BRAM13 | 0 | 0 | 0 | 0 | 0 | 0 | 0 | 0 | 0 | 0 | 0 | 0 | 0 | 1 | 0 | 0 | 1 | 0 | 1 | 0 | 0 | 1 | 0 | 1 | 1 | 1 | 0 | 0 | 1 | 1 |
| BRAM14 | 0 | 0 | 0 | 0 | 0 | 0 | 0 | 0 | 0 | 0 | 0 | 0 | 0 | 0 | 1 | 0 | 1 | 1 | 0 | 0 | 1 | 1 | 0 | 0 | 1 | 1 | 1 | 1 | 1 | 1 |
| BRAM15 | 0 | 0 | 0 | 0 | 0 | 0 | 0 | 0 | 0 | 0 | 0 | 0 | 0 | 0 | 0 | 1 | 1 | 0 | 0 | 0 | 0 | 1 | 1 | 1 | 1 | 1 | 0 | 0 | 1 | 1 |
| | | | | | | | | | | | | | | | | | 0 | 0 | 0 | 0 | 0 | 1 | 2 | 1 | 0 | 2 | 0 | 3 | 0 | 3 |

**ma2**

| COLUMN NUMBER | 0 | 1 | 2 | 3 | 4 | 5 | 6 | 7 | 8 | 9 | 10 | 11 | 12 | 13 | 14 | 15 | 16 | 17 | 18 | 19 | 20 | 24 | 26 | 28 | 21 | 23 | 25 | 22 | 27 | 29 |
|---|---|---|---|---|---|---|---|---|---|---|---|---|---|---|---|---|---|---|---|---|---|---|---|---|---|---|---|---|---|---|
| BRAM0 | 1 | 0 | 0 | 0 | 0 | 0 | 0 | 0 | 0 | 0 | 0 | 0 | 0 | 0 | 0 | 0 | 1 | 1 | 1 | 1 | 1 | 1 | 1 | 1 | 0 | 0 | 0 | 0 | 0 | 0 |
| BRAM1 | 0 | 1 | 0 | 0 | 0 | 0 | 0 | 0 | 0 | 0 | 0 | 0 | 0 | 0 | 0 | 0 | 1 | 0 | 1 | 1 | 1 | 0 | 1 | 0 | 1 | 1 | 0 | 0 | 0 | 0 |
| BRAM2 | 0 | 0 | 1 | 0 | 0 | 0 | 0 | 0 | 0 | 0 | 0 | 0 | 0 | 0 | 0 | 0 | 1 | 1 | 0 | 1 | 1 | 1 | 1 | 0 | 1 | 0 | 1 | 1 | 0 | 0 |
| BRAM3 | 0 | 0 | 0 | 1 | 0 | 0 | 0 | 0 | 0 | 0 | 0 | 0 | 0 | 0 | 0 | 0 | 1 | 0 | 0 | 1 | 1 | 0 | 1 | 0 | 0 | 0 | 1 | 1 | 1 | 1 |
| BRAM4 | 0 | 0 | 0 | 0 | 1 | 0 | 0 | 0 | 0 | 0 | 0 | 0 | 0 | 0 | 0 | 0 | 1 | 1 | 1 | 0 | 1 | 1 | 1 | 0 | 0 | 1 | 0 | 0 | 0 | 1 |
| BRAM5 | 0 | 0 | 0 | 0 | 0 | 1 | 0 | 0 | 0 | 0 | 0 | 0 | 0 | 0 | 0 | 0 | 1 | 0 | 1 | 0 | 1 | 1 | 0 | 0 | 1 | 1 | 1 | 0 | 1 | 0 |
| BRAM6 | 0 | 0 | 0 | 0 | 0 | 0 | 1 | 0 | 0 | 0 | 0 | 0 | 0 | 0 | 0 | 0 | 1 | 1 | 0 | 0 | 1 | 0 | 1 | 0 | 1 | 0 | 0 | 1 | 1 | 1 |
| BRAM7 | 0 | 0 | 0 | 0 | 0 | 0 | 0 | 1 | 0 | 0 | 0 | 0 | 0 | 0 | 0 | 0 | 1 | 0 | 0 | 1 | 0 | 1 | 1 | 1 | 0 | 0 | 1 | 1 | 1 | 0 |
| BRAM8 | 0 | 0 | 0 | 0 | 0 | 0 | 0 | 0 | 1 | 0 | 0 | 0 | 0 | 0 | 0 | 0 | 1 | 1 | 1 | 1 | 0 | 0 | 1 | 0 | 1 | 0 | 1 | 1 | 0 | 1 |
| BRAM9 | 0 | 0 | 0 | 0 | 0 | 0 | 0 | 0 | 0 | 1 | 0 | 0 | 0 | 0 | 0 | 0 | 1 | 0 | 1 | 1 | 0 | 0 | 0 | 1 | 1 | 1 | 1 | 0 | 1 | 0 |
| BRAM10 | 0 | 0 | 0 | 0 | 0 | 0 | 0 | 0 | 0 | 0 | 1 | 0 | 0 | 0 | 0 | 0 | 1 | 1 | 0 | 1 | 0 | 1 | 0 | 1 | 1 | 1 | 0 | 0 | 1 | 1 |
| BRAM11 | 0 | 0 | 0 | 0 | 0 | 0 | 0 | 0 | 0 | 0 | 0 | 1 | 0 | 0 | 0 | 0 | 1 | 0 | 1 | 0 | 1 | 1 | 1 | 0 | 0 | 0 | 1 | 1 | 0 | 1 |
| BRAM12 | 0 | 0 | 0 | 0 | 0 | 0 | 0 | 0 | 0 | 0 | 0 | 0 | 1 | 0 | 0 | 0 | 1 | 1 | 1 | 0 | 0 | 0 | 1 | 1 | 1 | 0 | 0 | 0 | 1 | 0 |
| BRAM13 | 0 | 0 | 0 | 0 | 0 | 0 | 0 | 0 | 0 | 0 | 0 | 0 | 0 | 1 | 0 | 0 | 1 | 0 | 1 | 0 | 0 | 1 | 0 | 1 | 1 | 1 | 1 | 1 | 1 | 1 |
| BRAM14 | 0 | 0 | 0 | 0 | 0 | 0 | 0 | 0 | 0 | 0 | 0 | 0 | 0 | 0 | 1 | 0 | 1 | 1 | 0 | 0 | 0 | 0 | 1 | 1 | 1 | 1 | 0 | 1 | 1 | 1 |
| BRAM15 | 0 | 0 | 0 | 0 | 0 | 0 | 0 | 0 | 0 | 0 | 0 | 0 | 0 | 0 | 0 | 1 | 1 | 0 | 0 | 0 | 0 | 1 | 0 | 1 | 1 | 1 | 1 | 1 | 0 | 1 |
| | | | | | | | | | | | | | | | | | 0 | 0 | 0 | 0 | 0 | 0 | 0 | 0 | 1 | 1 | 2 | 2 | 3 | 3 |

EP 3 119 005 A1

FIG.35

55

# FIG.36

START

ACQUIRE ENCODING MATRIX
AND ACCELERATION
NUMBER
— S3601

COUNT NUMBER OF CONSECUTIVE
ZEROS FROM FIRST COMPONENT FOR
EACH OF COLUMN VECTORS AFTER
(INPUT BLOCK NUMBER)-th COLUMN
IN ENCODING MATRIX
— S3602

SORT COLUMN VECTORS AFTER
(INPUT BLOCK NUMBER)-th COLUMN
IN ENCODING MATRIX IN ASCENDING
ORDER OF COUNTING RESULTS
— S3603

IDENTIFY BLOCK TO BE
ERASED FOR EACH OF
TIMINGS OF ERASURE BASED
ON ACCELERATION NUMBER
— S3604

S3605

BLOCKS TO BE
ERASED AND IDENTIFIED FOR
TIMINGS OF ERASURE INCLUDE BLOCK
HAVING 1 AS COMPONENT OF COLUMN
VECTOR CORRESPONDING TO TIMING
OF ERASURE AND BLOCK
TO BE ERASED?

NO

YES

S3606

PROVIDE OUTPUT
INDICATING THAT
ENCODING CIRCUIT CAN BE
UTILIZED WITHOUT CHANGE

A

END

## FIG.37

```
        ┌─A─┐
```

ACQUIRE TEMPLATE LOGICAL EXPRESSION  S3701

GENERATE LOGICAL EXPRESSION FOR
EACH OF COLUMN VECTORS  S3702

GENERATE LOGICAL EXPRESSION X FOR
PERFORMING LOGICAL AND OPERATIONS
OF GENERATED LOGICAL EXPRESSIONS  S3703

OBTAIN VALUES OF VARIABLES OF
LOGICAL EXPRESSION X  S3704

IDENTIFY COMBINATION OF VALUES OF
VARIABLES SETTING LOGICAL EXPRESSION
X TO TRUE  S3705

IDENTIFY TIMING CORRESPONDING TO
COLUMN VECTOR BASED ON IDENTIFIED
COMBINATION  S3706

GENERATE CIRCUIT INFORMATION
REPRESENTATIVE OF ENCODING CIRCUIT
AND CONTROL CIRCUIT BASED ON
IDENTIFIED COMBINATION AND
IDENTIFIED TIMING  S3707

END

**INTERNATIONAL SEARCH REPORT**

| International application No. |
| --- |
| PCT/JP2014/056253 |

A. CLASSIFICATION OF SUBJECT MATTER
*H03M13/37*(2006.01)i, *H04L1/00*(2006.01)i

According to International Patent Classification (IPC) or to both national classification and IPC

B. FIELDS SEARCHED

Minimum documentation searched (classification system followed by classification symbols)
H03M13/37, H04L1/00

Documentation searched other than minimum documentation to the extent that such documents are included in the fields searched
Jitsuyo Shinan Koho   1922–1996   Jitsuyo Shinan Toroku Koho   1996–2014
Kokai Jitsuyo Shinan Koho   1971–2014   Toroku Jitsuyo Shinan Koho   1994–2014

Electronic data base consulted during the international search (name of data base and, where practicable, search terms used)
IEEE Xplore, CiNii

C. DOCUMENTS CONSIDERED TO BE RELEVANT

| Category* | Citation of document, with indication, where appropriate, of the relevant passages | Relevant to claim No. |
| --- | --- | --- |
| A | JP 2012-49757 A (Fujitsu Ltd.),<br>08 March 2012 (08.03.2012),<br>paragraphs [0015] to [0052]<br>& US 2012/0054574 A1 | 1-7 |
| A | JP 2012-249305 A (Digital Fountain, Inc.),<br>13 December 2012 (13.12.2012),<br>abstract; claims 1 to 13; paragraphs [0098] to [0100]<br>& JP 2008-544610 A   & JP 5231218 B<br>& US 2006/0280254 A1   & EP 1894376 A<br>& WO 2006/135878 A2   & WO 2006/135878 B<br>& KR 10-2008-0040669 A   & CN 101243664 A | 1-7 |

| ☒   Further documents are listed in the continuation of Box C. | ☐   See patent family annex. |
| --- | --- |

| *   Special categories of cited documents: | "T"   later document published after the international filing date or priority date and not in conflict with the application but cited to understand the principle or theory underlying the invention |
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search<br>07 May, 2014 (07.05.14) | Date of mailing of the international search report<br>17 June, 2014 (17.06.14) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2014/056253

C (Continuation). DOCUMENTS CONSIDERED TO BE RELEVANT

| Category* | Citation of document, with indication, where appropriate, of the relevant passages | Relevant to claim No. |
|---|---|---|
| A | Yuichi KAJI, "Encoding LDPC codes by Utilising the Triangular Factorization of Binary Matrices", IEICE Technical Report, 12 May 2004 (12.05.2004), vol.104, no.52, pages 7 to 12, IT2004-2 | 1-7 |
| A | Jianqiang Luo et al., Efficient Encoding Schedules for XOR-based Erasure Codes, Computers, IEEE Transactions on, 2013.05.31, pp.1-14 | 1-7 |

Form PCT/ISA/210 (continuation of second sheet) (July 2009)

## REFERENCES CITED IN THE DESCRIPTION

**Patent documents cited in the description**

- JP 2007258796 A
- JP H10190481 B
- JP 2005102037 A

**Non-patent literature cited in the description**

- **KAMEYAMA, H. ; SATO, Y.** Construction of High-Speed ASP System for Engineering Application Handling Large-Scale Data. *Multimedia, Distributed, Corporative, and Mobile (DICOMO 2008) Symposium,* 06 December 2013, http://www.dico-mo.org/2008/program/3H_abst.html